(19)

Europäisches
Patentamt

European
Patent Office

Office européen
des brevets

(11) **EP 4 598 315 A1**

(12) **EUROPEAN PATENT APPLICATION**

(43) Date of publication:
06.08.2025 Bulletin 2025/32

(21) Application number: 25155215.4

(22) Date of filing: 31.01.2025

(51) International Patent Classification (IPC):
*H10K 50/115* (2023.01)    *H10K 50/16* (2023.01)
*H10K 102/00* (2023.01)

(52) Cooperative Patent Classification (CPC):
**H10K 50/115; H10K 50/16;** H10K 2102/331

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 02.02.2024 KR 20240016802

(71) Applicant: Samsung Electronics Co., Ltd.
Suwon-si, Gyeonggi-do 16677 (KR)

(72) Inventors:
• CHUNG, You Jung
16678 Suwon-si (KR)
• KIM, Sung Woo
16678 Suwon-si (KR)

• HWANG, Sungwoo
16678 Suwon-si (KR)
• KIM, Jina
16678 Suwon-si (KR)
• PARK, Su Jin
16678 Suwon-si (KR)
• LEE, Ilyoung
16678 Suwon-si (KR)
• CHUNG, Heejae
16678 Suwon-si (KR)
• CHA, Soonmin
16678 Suwon-si (KR)

(74) Representative: Elkington and Fife LLP
Prospect House
8 Pembroke Road
Sevenoaks, Kent TN13 1XR (GB)

(54) **ELECTROLUMINESCENT DEVICE, PRODUCTION METHOD THEREOF, AND DISPLAY DEVICE INCLUDING THE SAME**

(57) An electroluminescent device, a producing method thereof, and a display device including the same. The electroluminescent device includes a first electrode and a second electrode spaced apart from each other; a light-emitting layer disposed between the first and second electrodes; and an electron transport layer between the light-emitting layer and the second electrode. The light-emitting layer includes a semiconductor nanoparticle, the electron transport layer includes a zinc oxide nanoparticle having a size of 1 nm or more to 15 nm or less, and the zinc oxide nanoparticle further includes magnesium, an alkali metal, and sulfur.

FIG. 1

EP 4 598 315 A1

**Description**

FIELD OF THE INVENTION

The present disclosure relates to a light-emitting (e.g., electroluminescent) device, a production method thereof, and a display device including the electroluminescent device.

BACKGROUND OF THE INVENTION

A semiconductor nanoparticle (e.g., a semiconductor nanocrystal particle) having a size in the nanometer range may exhibit luminescent properties. For example, a quantum dot including a semiconductor nanocrystal may exhibit a quantum confinement effect. The light emission from the semiconductor nanoparticle may occur when an electron in an excited state resulting from light excitation or an applied voltage moves from a conduction band to a valence band. The semiconductor nanoparticle may emit light of a desired wavelength region by adjusting a size of the semiconductor nanoparticle, a composition of the semiconductor nanoparticle, or a combination thereof. The semiconductor nanoparticle may be used, for example, in a light-emitting device (e.g., an electroluminescent device) or a display device including the electroluminescent device. There remains a need for an improved light-emitting device.

SUMMARY OF THE INVENTION

An embodiment provides a light-emitting device that emits light, for example, by applying a voltage to a nanostructure (e.g., a semiconductor nanoparticle such as a quantum dot), for example with or without a separate irradiation light source.

An embodiment provides a method of manufacturing the light emitting device.

An embodiment provides a display device (e.g., a quantum dot-light-emitting diode (QD-LED) display device) that includes a semiconductor nanoparticle such as a quantum dot as a component of a light-emitting layer in a pixel configuration (e.g., in a configuration of a blue pixel, a red pixel, a green pixel, or a combination thereof).

In an embodiment, an electroluminescent device includes: a first electrode and a second electrode spaced apart from each other (e.g., each electrode having a surface opposite the other); a light-emitting layer disposed between the first electrode and the second electrode; and an electron transport layer disposed between the light-emitting layer and the second electrode, wherein the electron transport layer includes a zinc oxide nanoparticle (e.g., a plurality of zinc oxide nanoparticles), wherein the zinc oxide nanoparticle has a size of 1 nanometer or greater and 15 nanometers or less, wherein the zinc oxide nanoparticle includes magnesium, an alkali metal, and sulfur, and wherein the light-emitting layer includes a semiconductor nanoparticle (e.g., a plurality of semiconductor nanoparticles).

In the zinc oxide nanoparticle, a mole ratio of alkali metal to sulfur (alkali metal:sulfur) may be greater than or equal to about 0.01:1 and less than or equal to about 6:1.

The alkali metal may include lithium, sodium, potassium, rubidium, cesium, or a combination thereof. The alkali metal may include potassium, cesium, rubidium, or a combination thereof. The alkali metal may include lithium, sodium, potassium, or a combination thereof; and optionally cesium, rubidium, or a combination thereof.

In the zinc oxide nanoparticle, a mole ratio of alkali metal to sulfur (alkali metal:sulfur) may be greater than or equal to about 0.03:1 and less than or equal to about 5:1, less than or equal to about 3:1, less than or equal to about 1:1, or less than or equal to about 0.9:1.

In the zinc oxide nanoparticle, a mole ratio of alkali metal to sulfur (alkali metal:sulfur) may be greater than or equal to about 0.1:1 and less than or equal to about 0.7:1.

In the zinc oxide nanoparticle, a mole ratio of magnesium to sulfur (magnesium:sulfur) may be greater than or equal to about 0.1:1 and less than or equal to about 30:1.

In the zinc oxide nanoparticle, a mole ratio of magnesium to sulfur (magnesium:sulfur) may be greater than or equal to about 2:1 and less than or equal to about 25:1.

In the zinc oxide nanoparticle or in the electron transport layer, a mole ratio of magnesium to zinc (Mg:Zn) may be greater than or equal to about 0.1:1, or greater than or equal to about 0.12:1 and less than or equal to about 0.5:1, less than or equal to about 0.3:1, or less than or equal to about 0.25:1.

In the zinc oxide nanoparticle or in the electron transport layer, a mole ratio of alkali metal to magnesium (alkali metal:Mg) may be greater than or equal to about 0.03:1, or greater than or equal to about 0.08:1 and less than or equal to about 0.5:1 or less than or equal to about 0.25:1.

In the zinc oxide nanoparticle or in the electron transport layer, a mole ratio of alkali metal to zinc (alkali metal:Zn) may be greater than or equal to about 0.002:1, or greater than or equal to about 0.01:1 and less than or equal to about 0.1:1, or less than or equal to about 0.05:1.

The zinc oxide nanoparticle may exhibit an S2p peak in a range of binding energy 160 eV to 164 eV in XPS analysis.

The zinc oxide nanoparticle may have a first absorption peak wavelength in the UV-Vis absorption spectrum in a range of greater than or equal to about 280 nm, or greater than or equal to about 285 nm and less than or equal to about 312 nm, less than or equal to about 310 nm, less than or equal to about 305 nm, or less than or equal to about 302 nm.

The zinc oxide nanoparticle may have a size or an average size (hereinafter, which may be referred to as "size") of greater than or equal to about 1 nm, for example, greater than or equal to about 3 nm. The size of the zinc oxide nanoparticle may be less than or equal to about 14 nm, less than or equal to about 10 nm, less than or equal to about 8 nm, less than or equal to about 5 nm, or less than or equal to about 4 nm.

The electron transport layer may be disposed adjacent to the light-emitting layer (e.g., directly on the light-emitting layer). In an embodiment, the electron transport layer may contact the light-emitting layer.

The light-emitting layer may be configured to emit a first light. The first light may be blue light. The first light or the blue light may have a peak emission wavelength of greater than or equal to about 440 nm to less than or equal to about 480 nm. The first light may be a red light. The first light or the red light may have an emission peak wavelength of greater than or equal to about 600 nm and less than or equal to about 650 nm. The first light may be a green light. The first light or the green light may have an emission peak wavelength of greater than or equal to about 500 nm and less than or equal to about 560 nm.

The electroluminescent device may further include a hole auxiliary layer between the light-emitting layer and the first electrode. The hole auxiliary layer may include a hole transport layer (e.g., including an organic compound), a hole injection layer, or a combination thereof.

The semiconductor nanoparticle, or the light-emitting layer, may not include cadmium.

The semiconductor nanoparticle, or the light-emitting layer, may not include lead, mercury, or a combination thereof

The semiconductor nanoparticle may include a first semiconductor nanocrystal including zinc, selenium, and tellurium, and a second semiconductor nanocrystal including a zinc chalcogenide, the second semiconductor nanocrystal being different from the first semiconductor nanocrystal.

The semiconductor nanoparticle may include a first semiconductor nanocrystal including a Group III-V compound or an indium phosphide compound, each including indium, phosphorus, and optionally zinc; and a second semiconductor nanocrystal including a zinc chalcogenide and different from the first semiconductor nanocrystal.

The semiconductor nanoparticle may include a zinc chalcogenide, wherein the zinc chalcogenide may include selenium, tellurium, or a combination thereof and the semiconductor nanoparticle may emit blue light.

The semiconductor nanoparticle may have a core-shell structure that includes a core including the first semiconductor nanocrystal and a shell disposed on the core and including the second semiconductor nanocrystal.

A thickness of the electron transport layer may be greater than or equal to about 5 nm. A thickness of the electron transport layer may be less than or equal to about 70 nm.

In an electroluminescent device of an embodiment, an electron auxiliary layer including a zinc oxide nanoparticle may be disposed between the second electrode and the light emitting layer, and as a voltage of 0 volts to 8 volts is applied to the device thus obtained, a current density at 8 volts during a third sweep may be greater than or equal to about 100 milliamperes per square centimeter ($mA/cm^2$),

The electroluminescent device has a maximum external quantum efficiency of greater than or equal to about 4 %, greater than or equal to about 6 %, greater than or equal to about 7 %, greater than or equal to about 8 %, greater than or equal to about 9 %, greater than or equal to about 10 %. The maximum external quantum efficiency may be from about 4 % to 50 %, or from about 10 % to about 40 %.

The electroluminescent device may have a maximum luminance of greater than or equal to about 40,000 candela per square meter ($cd/m^2$), greater than or equal to about 60,000 $cd/m^2$, or greater than or equal to about 100,000 $cd/m^2$. The maximum luminance may be less than or equal to about 5,000,000 $cd/m^2$.

The electroluminescent device may exhibit a half-life (T50) of greater than or equal to about 90 hours, greater than or equal to about 100 hours, greater than or equal to about 150 hours, greater than or equal to about 240 hours, greater than or equal to about 300 hours, greater than or equal to about 400 hours, greater than or equal to about 500 hours, or greater than or equal to about 600 hours (e.g., as being measured at a predetermined initial luminance, e.g., an initial luminance of 650 nit). The T50 may be from about 100 hours to about 3000 hours, from about 120 hours to about 2000 hours, from about 170 hours to about 1000 hours, or any combination of the foregoing upper and lower limits.

The electroluminescent device may exhibit a T90 of greater than or equal to about 25 hours, greater than or equal to about 50 hours, or greater than or equal to about 90 hours (e.g., as being measured at a predetermined initial luminance, e.g., an initial luminance of 650 nit). The T90 may be from about 25 hours to about 800 hours, or from about 30 hours to about 300 hours.

An embodiment relates to a method for producing the aforementioned electroluminescent device. The method may include: disposing (e.g., forming) the light-emitting layer on the first electrode; disposing the zinc oxide nanoparticle onto the light-emitting layer to form the electron transport layer; and disposing (e.g., forming) the second electrode on the electron transport layer, wherein preparation of the zinc oxide nanoparticle includes: contacting a zinc oxide nanoparticle containing magnesium with an alkali metal sulfide in a reaction solvent.

The contacting of the zinc oxide nanoparticle with the alkali metal sulfide may include dispersing the zinc oxide nanoparticle containing the magnesium in the reaction solvent; adding an organic solution of the alkali metal sulfide to the reaction solvent; and stirring a resulting mixture.

An amount of the alkali metal sulfide may be greater than or equal to about 0.001 moles, greater than or equal to about 0.003 moles, greater than or equal to about 0.005 moles, greater than or equal to about 0.009 moles, greater than or equal to about 0.01 moles, greater than or equal to about 0.04 moles, and less than or equal to about 1 mole, less than or equal to about 0.5 moles, less than or equal to about 0.2 moles, less than or equal to about 0.15 moles, or less than or equal to about 0.05 moles per a 1 mole of a sum of zinc and magnesium.

The reaction solvent may include a C1-C5 alcohol (e.g., ethanol), a dialkyl sulfoxide solvent having a C1-C10 alkyl group (e.g., dimethyl sulfoxide), or a combination thereof.

An amount of water in the reaction solvent may be less than or equal to about 2 wt%, less than or equal to about 1.5 wt%, less than or equal to about 1 wt%, less than or equal to about 0.5 wt%, less than or equal to about 0.1 wt%, or less than or equal to about 0.01 wt% based on a total weight of the reaction solvent. The reaction solvent may substantially not include water.

The organic solution of the alkali metal sulfide may be prepared by dissolving the alkali metal sulfide in dimethyl sulfoxide.

The disposed electron transport layer may be heat-treated.

In an embodiment, a display device or an electronic apparatus may include the electroluminescent device.

The display device or an electronic apparatus may include (or may be) an augmented reality (AR) device, a virtual reality (VR) device, a handheld terminal (e.g., device), a monitor, a notebook computer, a television, an electronic display board, a camera, an electronic display component for an automatic vehicle, or an electric car, or the like.

According to an embodiment, an electroluminescent device that may simultaneously exhibit desired levels of electroluminescent characteristics with increased lifespan is provided. The nanoparticles included in the electron transport layer of an embodiment, which include alkali metal and sulfur provided from alkali metal sulfide, may show a substantial reduction in particle trap emission observed around 500 nm when excited with a light having a wavelength of 300 nm. Additionally, a device including the zinc oxide nanoparticle treated with alkali metal sulfide in the electron transport layer of an embodiment may show a reduction in the increase of voltage over time during operation (delta V reduction).

BRIEF DESCRIPTION OF THE DRAWINGS

The above and other advantages and features of this disclosure will become more apparent by describing in further detail exemplary embodiments thereof with reference to the accompanying drawings, in which:

FIG. 1 is a schematic cross-sectional view of an exemplary embodiment of an electroluminescent device.
FIG. 2 is a schematic cross-sectional view of an exemplary embodiment of an electroluminescent device.
FIG. 3 is a schematic cross-sectional view of an exemplary embodiment of an electroluminescent device.
FIG. 4 is a schematic cross-sectional view of a QD LED device according to another non-limiting embodiment.
FIG. 5 is a schematic cross-sectional view of a light emitting device (RGB pixel) according to an embodiment.
FIG. 6 is a schematic front view of a display panel according to an embodiment.
FIG. 7 is a schematic cross-sectional view of the display panel of FIG. 6 taken along line IV-IV.
FIG. 8 is a graph of the ultraviolet-visible (UV-Vis) absorption spectroscopy results (arbitrary units (a.u.) vs. wavelength (nanometers (nm))) of zinc oxide nanoparticles prepared in Preparation Examples 1 to 2 and Comparative Preparation Example 1.
FIG. 9 shows the photoluminescence spectrums (intensity (a.u.) vs. wavelength (nm)) (e.g., for trap emission) of zinc oxide nanoparticles prepared in Preparation Examples 1 to 3 and Comparative Preparation Example 1.
FIG. 10 shows the XPS results (intensity (a.u.) vs. binding energy (electronvolts (eV))) of the zinc oxide nanoparticles prepared in Preparation Example 3.
FIG. 11 shows a photoluminescence spectrum (intensity (a.u.) vs. wavelength (nm)) of Experimental Example 2.
FIG. 12 shows a TRPL spectrum (photoluminescence (PL) intensity vs. time (nanoseconds (ns))) of Experimental Example 2.

DETAILED DESCRIPTION

Advantages and characteristics of this disclosure, and a method for achieving the same, will become evident referring to the following exemplary embodiments together with the drawings attached hereto. However, this invention may, be embodied in many different forms, the embodiments should not be construed as being limited to the embodiments set forth herein. Rather, these embodiments are provided so that this disclosure will be thorough and complete, and will fully convey the scope of the invention to those skilled in the art. Like reference numerals refer to like elements throughout.

In order to clearly explain the present disclosure, parts irrelevant to the description are omitted, and the same reference numerals are assigned to the same or similar elements throughout the specification. In the drawings, the thickness of layers, films, panels, regions, etc., are exaggerated for clarity. And in the drawings, for convenience of description, the thickness of some layers and regions are exaggerated. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

In addition, it will be understood that when an element such as a layer, film, region, or substrate is referred to as being "on" another element, it may be directly on the other element or intervening elements may also be present. In contrast, when an element is referred to as being "directly on" another element, there are no intervening elements present. Also, to be disposed "on" the reference portion means to be disposed above or below the reference portion and does not necessarily mean "above".

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" may, therefore, encompass both an orientation of above and below.

It will be understood that, although the terms "first," "second," "third," etc., may be used herein to describe various elements, components, regions, layers and/or sections, these elements, components, regions, layers and/or sections should not be limited by these terms. These terms are only used to distinguish one element, component, region, layer or section from another element, component, region, layer, or section. Thus, "a first element," "component," "region," "layer," or "section" discussed below could be termed a second element, component, region, layer, or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. "At least one" is not to be construed as being limited to "a" or "an." "Or" means "and/or."

As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

As used herein, the term "cross-sectional" means a case in which a cross-section of a given object is cut, for example, in a substantially vertical direction and is viewed laterally.

Unless otherwise defined, all terms (including technical and scientific terms) used herein have the same meaning as commonly understood by one of ordinary skill in the art to which this disclosure belongs. It will be further understood that terms, such as those defined in commonly used, e.g., non-technical, dictionaries, should be interpreted as having a meaning that is consistent with their meaning in the context of the relevant art and the present disclosure, and will not be interpreted in an idealized or overly formal sense unless expressly so defined herein.

As used herein, values of a work function, a conduction band, or a lowest unoccupied molecular orbital (LUMO) (or valence band, or highest occupied molecular orbital (HOMO)) energy level is expressed as an absolute value from a vacuum level. In addition, when the work function or the energy level is referred to be "deep," "high" or "large," the work function or the energy level has a large absolute value based on 0 electron volts (eV) of the vacuum level, while when the work function or the energy level is referred to be "shallow," "low," or "small," the work function or energy level has a small absolute value based on 0 eV of the vacuum level. In an aspect, work function herein refers to a minimum energy required to remove an electron from e.g., a solid metal (e.g., a metal surface) to vacuum (e.g., immediately outside the solid surface).

As used herein, the term "first absorption peak" refers to a main excitonic peak appearing first from the longest wavelength region of a UV-vis absorption spectrum (i.e., appearing in the lowest energy region in the UV-Vis absorption spectrum), and the term "first absorption peak wavelength" or "wavelength of the first absorption peak" refers to the wavelength at which the first absorption peak reaches a maximum intensity.

As used herein, the average (value) may be mean or median. In an embodiment, the average (value) may be a mean value.

As used herein, the term "peak emission wavelength" is the wavelength at which a given emission spectrum of the light reaches its maximum.

As used herein, the term "Group" may refer to a group of Periodic Table.

As used herein, "Group I" refers to Group IA and Group IB, and examples may include Li, Na, K, Rb, and Cs, but are not limited thereto.

As used herein, "Group II" refers to Group IIA and Group IIB, and examples of Group II metal may be Cd, Zn, Hg, and Mg, but are not limited thereto.

As used herein, "Group III" refers to Group IIIA and Group IIIB, and examples of Group IIIA metal may be Al, In, Ga, and Tl, and examples of Group IIIB may be scandium, yttrium, or the like, but are not limited thereto.

As used herein, "Group IV" refers to Group IVA and Group IVB, and examples of a Group IVA metal may be Si, Ge, and Sn, and examples of Group IVB metal may be titanium, zirconium, hafnium, or the like, but are not limited thereto.

As used herein, "Group V" includes Group VA and includes nitrogen, phosphorus, arsenic, antimony, and bismuth, but is not limited thereto.

As used herein, "Group VI" includes Group VIA and includes sulfur, selenium, and tellurium, but is not limited thereto.

As used herein, "metal" includes a semi-metal such as Si.

As used herein, a number of carbon atoms in a group or a molecule may be referred to as a subscript (e.g., $C_{6-50}$) or as C6-C50.

As used herein, when a definition is not otherwise provided, "substituted" refers to replacement of at least one hydrogen of a compound or a group with a corresponding substituent including a C1 to C30 alkyl group, a C2 to C30 alkenyl group, a C2 to C30 alkynyl group, a C6 to C30 aryl group, a C7 to C30 alkylaryl group, a C1 to C30 alkoxy group, a C1 to C30 heteroalkyl group, a C3 to C30 heteroaryl group, a C3-C30 cycloalkyl group, a C3-C15 cycloalkenyl group, a C6-C30 cycloalkynyl group, a C2-C30 heterocycloalkyl group, a halogen (-F, -Cl, -Br, or -I), a hydroxy group (-OH), a nitro group ($-NO_2$), a cyano group (-CN), an amino group (-NRR' wherein R and R' are each independently hydrogen or a C1-C6 alkyl group), an azido group ($-N_3$), an amidino group ($-C(=NH)NH_2$), a hydrazino group ($-NHNH_2$), a hydrazono group ($=N(NH_2)$), an aldehyde group (-C(=O)H), a carbamoyl group ($-C(O)NH_2$), a thiol group (-SH), an ester group (-C(=O) OR, wherein R is a C1-C6 alkyl group or a C6-C12 aryl group), a carboxyl group (-COOH) or a salt thereof (-C(=O)OM, wherein M is an organic or inorganic cation), a sulfonic acid group (-SOsH) or a salt thereof (-SOsM, wherein M is an organic or inorganic cation), a phosphoric acid group ($-PO_3H_2$) or a salt thereof (-POsMH or - $PO_3M_2$, wherein M is an organic or inorganic cation), or a combination thereof. As used herein, when a definition is not otherwise provided, "hydrocarbon" or "hydrocarbon group" refers to a compound or a group including carbon and hydrogen (e.g., alkyl, alkenyl, alkynyl, or aryl group). The hydrocarbon group may be a monovalent group or a group having a valence of greater than one formed by removal of one or more hydrogen atoms from an alkane, an alkene, an alkyne, or an arene group. In the hydrocarbon or hydrocarbon group, at least one, methylene may be replaced by an oxide moiety, a carbonyl moiety, an ester moiety, -NH-, or a combination thereof. Unless otherwise stated to the contrary, the hydrocarbon or the hydrocarbon group (alkyl, alkenyl, alkynyl, or aryl) may have 1 to 60, 2 to 32, 3 to 24, or 4 to 12 carbon atoms.

As used herein, when a definition is not otherwise provided, "alkyl" refers to a linear or branched saturated monovalent hydrocarbon group (methyl, ethyl hexyl, or the like). In an embodiment, an alkyl group may have from 1 to 50 carbon atoms, or 1 to 18 carbon atoms, or 1 to 12 carbon atoms.

As used herein, when a definition is not otherwise provided, "alkenyl" refers to a linear or branched monovalent hydrocarbon group having a carbon-carbon double bond. In an embodiment, an alkenyl group may have from 2 to 50 carbon atoms, or 2 to 18 carbon atoms, or 2 to 12 carbon atoms.

As used herein, when a definition is not otherwise provided, "alkynyl" refers to a linear or branched monovalent hydrocarbon group having a carbon-carbon triple bond. In an embodiment, an alkenyl group may have from 2 to 50 carbon atoms, or 2 to 18 carbon atoms, or 2 to 12 carbon atoms.

As used herein, when a definition is not otherwise provided, "aryl" refers to a group having a carbocyclic aromatic system. When the aryl group includes a plurality of rings, the plurality of rings may be fused to each other. Examples include a phenyl group and a naphthyl group. In an embodiment, an aryl group may have 6 to 50 carbon atoms, or 6 to 18 carbon atoms, or 6 to 12 carbon atoms.

As used herein, when a definition is not otherwise provided, "hetero" refers to inclusion of 1 to 3 heteroatoms, e.g., N, O, P, Si, B, Se, Ge, Te, S, or a combination thereof.

As used herein, "heteroaryl" refers to an aromatic system having at least one N, O, P, Si, B, Se, Ge, Te, S, or a combination thereof as a ring forming atom. Examples of heteroaryl groups include a pyridinyl group, a pyrimidinyl group, a pyrazinyl group, a pyridazinyl group, a triazinyl group, a quinolinyl group, and an isoquinolinyl group. When the heteroaryl group includes a plurality of rings, the plurality of rings may be fused to each other. In an embodiment, the heteroaryl group may have 3 to 50 carbon atoms, or 6 to 18 carbon atoms, or 6 to 12 carbon atoms.

As used herein, when a definition is not otherwise provided, "alkoxy" refers to an alkyl group linked to oxygen (e.g., alkyl-O-) for example, a methoxy group, an ethoxy group, or a sec-butyloxy group.

The term "cycloalkyl group" as used herein refers to a monovalent monocyclic saturated hydrocarbon group. Examples thereof include a cyclopropyl group, a cyclobutyl group, a cyclopentyl group, a cyclohexyl group, and a cycloheptyl group. In an embodiment, the cycloalkyl group may have 3 to 50 carbon atoms, or 3 to 18 carbon atoms, or 3 to 12 carbon atoms.

The term "heterocycloalkyl group" as used herein refers to a monovalent monocyclic group including at least one N, O, P, Si, B, Se, Ge, Te, S, or a combination thereof as a ring-forming atom in addition to the carbon atoms that are ring-forming atoms. Examples thereof include a tetrahydrofuranyl group and a tetrahydrothiophenyl group. In an embodiment, the heterocycloalkyl group may have 2 to 50 carbon atoms, or 2 to 18 carbon atoms, or 2 to 12 carbon atoms.

The term "cycloalkenyl group" as used herein refers to a monovalent monocyclic hydrocarbon group that has at least one carbon-carbon double bond in its ring, wherein the molecular structure as a whole is non-aromatic. Examples thereof include a cyclopentenyl group, a cyclohexenyl group, and a cycloheptenyl group. In an embodiment, the cycloalkenyl group may have 3 to 50 carbon atoms, or 3 to 18 carbon atoms, or 3 to 12 carbon atoms.

The term "heterocycloalkenyl group" as used herein refers to a monovalent monocyclic group including at least one N, O, P, Si, B, Se, Ge, Te, S, or a combination thereof as a ring-forming atom, and at least one double bond in its ring, wherein the molecular structure as a whole is non-aromatic. Examples of the heterocycloalkenyl group include a 2,3-dihydrofuranyl group and a 2,3-dihydrothiophenyl group. In an embodiment, the heterocycloalkenyl group may have 2 to 50 carbon atoms, or 2 to 18 carbon atoms, or 2 to 12 carbon atoms.

The term "arylalkyl group" refers to an alkyl group substituted with an aryl group. An example of an arylalkyl group is a benzyl group (i.e., -CH$_2$-phenyl).

The term "alkylaryl group" refers to an aryl group substituted with an alkyl group. An example of an alkylaryl group is a tolyl group.

As used herein, when a definition is not otherwise provided, "amine" is a compound represented by NR$_3$, wherein each R is independently hydrogen, a C1-C12 alkyl group, a C7-C20 alkylaryl group, a C7-C20 arylalkyl group, or a C6-C18 aryl group.

As used herein, the expression "not including cadmium (or other harmful heavy metal)" means that a concentration of cadmium (or another heavy metal deemed harmful) may be less than or equal to about 100 parts per million by weight (ppmw), less than or equal to about 50 ppmw, less than or equal to about 10 ppmw, less than or equal to about 1 ppmw, less than or equal to about 0.1 ppmw, less than or equal to about 0.01 ppmw, or zero. In an embodiment, substantially no amount of cadmium (or other toxic heavy metal) may be present or, if present, an amount of cadmium (or other heavy metal) may be less than or equal to a detection limit or as an impurity level of a given analysis tool (e.g., an inductively coupled plasma atomic emission spectroscopy instrument).

Unless mentioned to the contrary, a numerical range recited herein is inclusive. Unless mentioned to the contrary, a numerical range recited herein includes any real number within the endpoints of the stated range and includes the endpoints thereof. In this specification, a numerical endpoint or an upper or lower limit value (e.g., recited either as a "greater than or equal to value" "at least value" or a "less than or equal to value" or recited with "from" or "to") may be used to form a numerical range of a given feature. In other words, the upper and lower endpoints set forth for various numerical values may be independently combined to provide a range.

"About" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within $\pm10\%$, $\pm5\%$, $\pm3\%$, or $\pm1\%$ of the stated value.

As used herein, a nanoparticle is a structure having at least one region or characteristic dimension with a nanoscale dimension. In an embodiment, a dimension (or an average dimension) of the nanostructure is less than or equal to about 500 nanometers (nm), less than or equal to about 300 nm, less than or equal to about 250 nm, less than or equal to about 150 nm, less than or equal to about 100 nm, less than or equal to about 50 nm, or less than or equal to about 30 nm, and may be greater than about 0.1 nm or greater than about 1 nm. In an embodiment, the nanoparticle may have any suitable shape. The nanoparticle (e.g., a semiconductor nanoparticle or a metal oxide nanoparticle) may include a nanowire, a nanorod, a nanotube, a branched nanostructure, a nanotetrapod, a nanotripod, a nanobipod, a nanodot, a multi-pod type shape such as at least two pods, or the like and is not limited thereto. The nanoparticle may be, e.g., substantially crystalline, substantially monocrystalline, polycrystalline, (for example, at least partially) amorphous, or a combination thereof.

In an embodiment, a semiconductor nanoparticle such as a quantum dot may exhibit quantum confinement or exciton confinement. As used herein, the term "quantum dot" or "semiconductor nanostructure" is not limited in a shape thereof unless otherwise defined. A semiconductor nanoparticle or a quantum dot may have a size smaller than a Bohr excitation diameter for a bulk crystal material having an identical composition and may exhibit a quantum confinement effect. The semiconductor nanoparticle or the quantum dot may emit light corresponding to a bandgap energy thereof by controlling a size of a nanocrystal acting as an emission center.

As used herein, the term "T50" is a time (hours, hr) the brightness (e.g., luminance) of a given device decreases to 50% of the initial brightness (100%) as, e.g., when, the given device is started to be driven, e.g., operated, at a predetermined initial brightness (e.g., 650 nit or 146 nit).

As used herein, the term "T90" is a time (hr) the brightness (e.g., luminance) of a given device decreases to 90% of the initial brightness (100%) as the given device is started to be driven at a predetermined initial brightness (e.g., 650 nit or 146 nit).

As used herein, the phrase "external quantum efficiency" (EQE) is a ratio of the number of photons emitted from a light-emitting diode (LED) to the number of electrons passing through the device and may be a measurement as to how efficiently a given device converts electrons to photons and allows the photons to escape. The EQE may be determined by the following equation:

$$EQE = (\text{efficiency of injection}) \times ((\text{solid-state) quantum yield}) \times (\text{efficiency of extraction})$$

wherein the efficiency of injection is a proportion of electrons passing through the device that are injected into the active region, the quantum yield is a proportion of all electron-hole recombinations in the active region that are radiative and produce photons, and the efficiency of extraction is a proportion of photons generated in the active region that escape from the given device.

As used herein, a maximum EQE is a greatest value of the EQE.

As used herein, a maximum luminance is the highest value of luminance for a given device.

As used herein, the phrase "quantum efficiency" may be used interchangeably with the phrase "quantum yield." In an embodiment, the quantum efficiency may be a relative quantum yield or an absolute quantum yield, for example, which may be readily measured by any suitable, e.g., commercially available, equipment. The quantum efficiency (or quantum yield) may be measured in a solution state or a solid state (in a composite). In an embodiment, "quantum yield" (or "quantum efficiency") may be a ratio of photons emitted to photons absorbed, e.g., by a nanostructure or population of nanostructures. In an embodiment, the quantum efficiency may be determined by any suitable method. For example, there may be two methods for measuring the fluorescence quantum yield or efficiency: the absolute method and the relative method.

The absolute method directly obtains the quantum yield by detecting all sample fluorescence through the use of an integrating sphere. In the relative method, the fluorescence intensity of a standard sample (e.g., a standard dye) may be compared with the fluorescence intensity of an unknown sample to calculate the quantum yield of the unknown sample. Coumarin 153, Coumarin 545, Rhodamine 101 inner salt, Anthracene, and Rhodamine 6G may be used as standard dye, depending on the photoluminescence (PL) wavelengths thereof, but are not limited thereto.

As used herein, the term "dispersion" refers to a dispersion in which a dispersed phase is a solid, and a continuous medium includes a liquid or solid different from the dispersed phase. In an embodiment, the ink composition may be in a form of a dispersion. Herein, the "dispersion" may be a colloidal dispersion in which the dispersed phase has a dimension of greater than or equal to about 1 nm, for example, greater than or equal to about 2 nm, greater than or equal to about 3 nm, or greater than or equal to about 4 nm to several micrometers ($\mu$m) or less, (e.g., less than or equal to about 2 $\mu$m, less than or equal to about 1 $\mu$m, less than or equal to about 900 nm, less than or equal to about 800 nm, less than or equal to about 700 nm, less than or equal to about 600 nm, or less than or equal to about 500 nm).

A bandgap energy of a semiconductor nanoparticle may vary with a size and a composition of a nanocrystal. For example, as a size of the semiconductor nanoparticle increases, the bandgap energy of the semiconductor nanoparticle may become smaller, e.g., narrower, and the semiconductor nanoparticle may emit light having an increased wavelength. A semiconductor nanocrystal may be used as a light-emitting material in various fields such as in, a display device, an energy device, or a bio light-emitting device.

A semiconductor nanoparticle based electroluminescent device (hereinafter, also referred to as a QD-LED) may emit light by applying a voltage and includes a semiconductor nanoparticle or a quantum dot as a light-emitting material. The QD-LED is different from an organic light-emitting diode (OLED) in light of a specific emission principle and may exhibit light emission with more desirable optical properties, e.g., higher purity, improved colors (e.g., red, green, and blue), and improved color reproducibility and may draw attention as a material for a next generation display device. A method of producing the QD-LED may include a solution process, which may reduce manufacturing costs. In addition, a semiconductor nanoparticle in the QD-LED may be based on an inorganic material, contributing to realization of increased display (light emission) stability over time. However, it is still desirable to develop a technology that may further improve device properties and lifespan characteristics for the QD-LED.

In an embodiment, a structure of the QD-LED includes a light-emitting layer (EML) disposed between two electrodes (e.g., an anode and a cathode), and one or more auxiliary layers (e.g., a hole transport layer (HTL) and electron transport layer (ETL)) provided on opposite surfaces of the light-emitting layer, providing a charge balance and assisting an operation of a device. A QD-LED according to an embodiment may include an organic or inorganic hole auxiliary layer (e.g., organic or inorganic hole transport layer). A QD-LED according to an embodiment may include an inorganic material (e.g., a zinc oxide) in an electron auxiliary layer such as an electron transport layer (ETL). In the QD-LED of an embodiment, an electron auxiliary layer containing the inorganic material on the quantum dot-based light-emitting layer EML may be easily formed through a solution process, for example, a low-temperature process, and the electron auxiliary layer may provide improved mobility of electrons. A hole injected from the anode and an electron injected from the cathode may be supplied to the light-emitting layer through the auxiliary layers and an exciton may be formed and light may be emitted therefrom.

In the light-emitting layer, a quantum dot capable of exhibiting a practically applicable level of an electroluminescent property may include a harmful heavy metal such as cadmium (Cd), lead, mercury, or a combination thereof. Accordingly, it is desirable to provide a light-emitting device or a display device having a light-emitting layer substantially free of the harmful heavy metal. In conventional QD-LEDs, currently reported and satisfactory electroluminescent properties are mostly based on a cadmium-based (i.e., cadmium-containing) LED, and there is room for improvement in a QD-LED device using an environmentally-friendly quantum dot and for example emitting blue light that does not include cadmium or other harmful heavy metals.

In an embodiment of a QD-LED device, a zinc oxide nanoparticle having the features described herein may be included in the electronic auxiliary layer, and accordingly, the QD-LED including a cadmium free semiconductor nanoparticle in a light-emitting layer may exhibit a desired level of an electroluminescent property and an increased lifespan.

In an embodiment, an electroluminescent device may emit a desired light by applying a voltage, for example, with or without a separate light source.

The electroluminescent device in accordance with an exemplary embodiment includes zinc oxide nanoparticles including magnesium and aluminum in an electron transport layer, and may exhibit an extended life with improved electroluminescent properties.

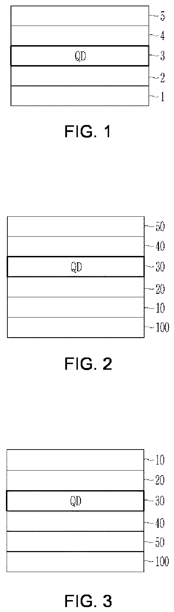

In an embodiment, an electroluminescent device includes a first electrode 1 and a second electrode 5 spaced apart from each other (e.g., each having a surface opposite the other, i.e., each with a surface facing each other); a light-emitting layer 3 disposed between the first electrode 1 and the second electrode 5 and including a semiconductor nanoparticle, and an electron transport layer 4 disposed between the light-emitting layer 3 and the second electrode 5 and including a zinc oxide nanoparticle. In an embodiment, the electroluminescent device may further include a hole auxiliary layer 2 between the light-emitting layer and the first electrode. The hole auxiliary layer may include a hole transport layer, a hole injection layer, or a combination thereof. The hole auxiliary layer may include an organic compound (see FIG. 1, FIG. 2, and FIG. 3).

In an embodiment, the first electrode or the second electrode may include an anode or a cathode. The first electrode may include an anode, and the second electrode may include a cathode. The first electrode may include a cathode and the second electrode may include an anode. In an embodiment, the second electrode includes a cathode. In the electroluminescent device of an embodiment, the first electrode 10 or the second electrode 50 may be disposed on a (transparent) substrate 100. The transparent substrate may be a light extraction surface (see, e.g., FIG. 2 and FIG. 3). The light-emitting layer may be disposed in a pixel (or a subpixel) of a display device described herein.

Referring to FIGS. 2 and 3, in an electroluminescent device of an embodiment, a light-emitting layer 30 may be disposed between a first electrode (e.g., anode) 10 and a second electrode (e.g., cathode) 50. The cathode 50 may include an electron injection conductor. The anode 10 may include a hole injection conductor. A work function of each of the electron or hole injection conductors included in the cathode and the anode may be appropriately adjusted and are not particularly limited. For example, the cathode may have a small work function and the anode may have a relatively large work function, or vice versa.

The electron or hole injection conductors may include a metal-based (i.e., metal-containing) material (e.g., a metal, a metal compound, an alloy, or a combination thereof) such as aluminum, magnesium, tungsten, nickel, cobalt, platinum, palladium, calcium, LiF, or the like; a metal oxide such as gallium indium oxide or indium tin oxide (ITO); or a conductive polymer (e.g., having a relatively high work function) such as polyethylene dioxythiophene, but are not limited thereto.

The first electrode, the second electrode, or a combination thereof may be a light-transmitting electrode or a transparent electrode. In an embodiment, both the first electrode and the second electrode may be a light-transmitting electrode. The first electrode, the second electrode, or a combination thereof may each be a patterned electrode.

The first electrode, the second electrode, or a combination thereof may be disposed on a (e.g., insulating) substrate 100. The substrate 100 may be optically transparent (e.g., may have a light transmittance of greater than or equal to about 50%, greater than or equal to about 60%, greater than or equal to about 70%, greater than or equal to about 80%, greater than or equal to about 85%, or greater than or equal to about 90% and, for example, less than or equal to about 99%, or less than or equal to about 95%). The substrate may have a transmittance of greater than or equal to about 50%, greater than or equal to about 60%, greater than or equal to about 70%, greater than or equal to about 80%, or greater than or equal to about 90% for light emitted from semiconductor nanoparticles that are described herein. The substrate 100 may include a region for a blue pixel, a region for a red pixel, a region for a green pixel, or a combination thereof. In an embodiment, a thin film (e.g., film) transistor may be disposed in each region of the substrate, but it is not limited thereto. In an embodiment, a source electrode or a drain electrode of the thin film transistor may be electrically connected to the first electrode or the second electrode.

The substrate 100 may be a rigid or a flexible substrate. The substrate 100 may be a substrate including an insulating material. The substrate may include glass; various polymers such as a polyester of polyethylene terephthalate (PET), polyethylene naphthalate (PEN), and the like, polycarbonate, and polyacrylate; a polysiloxane (e.g., polydimethylsiloxane (PDMS)); an inorganic material such as $Al_2O_3$ or ZnO; or a combination thereof but is not limited thereto. A thickness of the substrate may be appropriately selected taking into consideration a substrate material but is not particularly limited. In an embodiment, the light-transmitting electrode may be disposed on a (e.g., insulating) transparent substrate.

The electrode may include, for example, a transparent conductor such as an indium tin oxide (ITO) or an indium zinc oxide (IZO), a gallium indium tin oxide, a zinc indium tin oxide, a titanium nitride, a polyaniline, a LiF/Mg:Ag, and the like; or a metal thin film of a single layer or a plurality of layers, but it is not limited thereto. In an embodiment, one of the first electrode or the second electrode may include aluminum (Al), a lithium-aluminum (Li:Al) alloy, a magnesium-silver (Mg:Ag) alloy, or lithium fluoride-aluminum (LiF:Al) alloy. The first electrode or the second electrode may be or may include an opaque electrode.

The thickness of each electrode (the first electrode, the second electrode, or both) is not particularly limited and may be appropriately selected taking into consideration device efficiency. For example, the thickness of the electrode may be greater than or equal to about 5 nm, greater than or equal to about 10 nm, greater than or equal to about 20 nm, greater than or equal to about 30 nm, greater than or equal to about 40 nm, or greater than or equal to about 50 nm. For example, the thickness of the electrode may be less than or equal to about 100 micrometers ($\mu$m), less than or equal to about 90 $\mu$m, less than or equal to about 80 $\mu$m, less than or equal to about 70 $\mu$m, less than or equal to about 60 $\mu$m, less than or equal to about 50 $\mu$m, less than or equal to about 40 $\mu$m, less than or equal to about 30 $\mu$m, less than or equal to about 20 $\mu$m, less than or equal to about 10 $\mu$m, less than or equal to about 1 $\mu$m, less than or equal to about 900 nm, less than or equal to about 500 nm, or less than or equal to about 100 nm.

The method of forming the electrode is not particularly limited, and may be appropriately selected taking into consideration an electrode material. In an embodiment, the electrode may be formed by deposition, coating, or a combination thereof, but is not limited to these methods.

The light-emitting layer 3, or 30, may be disposed between the first electrode 1 and the second electrode 5 (e.g., the anode 10 and the cathode 50). The light-emitting layer may include a semiconductor nanoparticle (e.g., a plurality of semiconductor nanoparticles) such as a blue light-emitting nanoparticle, a red light-emitting nanoparticle, or a green light-emitting nanoparticle. The light-emitting layer may include one or more (e.g., 2 or more, or 3 or more, and 10 or less) monolayers of the semiconductor nanoparticle.

The light-emitting layer may be patterned (not shown). In an embodiment, the patterned light-emitting layer may include a blue light-emitting layer 30B disposed in the blue pixel. In an embodiment, the light-emitting layer may further include a red light-emitting layer disposed in the red pixel or a green light-emitting layer disposed in the green pixel. In an embodiment, the light-emitting layer may include a red light-emitting layer 30R disposed in the red pixel and a green light-emitting layer 30G disposed in the green pixel. Each of the (e.g., red, green, or blue) light-emitting layers may be (e.g., optically) separated from an adjacent light-emitting layer by a partition wall. In an embodiment, partition walls such as a black matrx or a pixel defining layer (PDL) may be disposed between the red light-emitting layer, the green light-emitting layer, and the blue light-emitting layer. The red light-emitting layer, the green light-emitting layer, and the blue light-emitting layer may be optically isolated from each other.

In an embodiment, the light-emitting layer 3, 30, or the semiconductor nanoparticle may not include cadmium. In an embodiment, the light-emitting layer 3, 30, or the semiconductor nanoparticle may not include mercury, lead, or a combination thereof.

In an embodiment, the semiconductor nanoparticle may have a core-shell structure. In an embodiment, the semiconductor nanoparticle or the core-shell structure may include a core including a first semiconductor nanocrystal and a shell disposed on the core and including a second semiconductor nanocrystal having a composition different from that of the first semiconductor nanocrystal.

The semiconductor nanoparticle (or the first semiconductor nanocrystal, the second semiconductor nanocrystal, or a combination thereof) may include a Group II-VI compound, a Group III-V compound, a Group IV-VI compound, a Group IV element or compound, a Group I-III-VI compound, a Group II-III-VI compound, a Group I-II-IV-VI compound, or a combination thereof. In an embodiment, the light-emitting layer or the semiconductor nanoparticle (e.g., the first semiconductor nanocrystal, or the second semiconductor nanocrystal) may not include cadmium. In an embodiment, the light-emitting layer, or the semiconductor nanoparticle (e.g., the first semiconductor nanocrystal or the second semiconductor nanocrystal) may not include lead. In an embodiment, the light-emitting layer, or the semiconductor nanoparticle (e.g., the first semiconductor nanocrystal, or the second semiconductor nanocrystal) may not include a combination of lead and cadmium.

The Group II-VI compound may include a binary element compound such as ZnS, ZnSe, ZnTe, ZnO, HgS, HgSe, HgTe, MgSe, MgS, or a combination thereof; a ternary element compound such as ZnSeS, ZnSeTe, ZnSTe, HgSeS, HgSeTe, HgSTe, HgZnS, HgZnSe, HgZnTe, MgZnSe, MgZnS, or a combination thereof; a quaternary element compound such as HgZnTeS, HgZnSeS, HgZnSeTe, HgZnSTe, or a combination thereof; or a combination thereof. The Group II-VI compound may further include a Group III metal.

The Group III-V compound may include a binary element compound such as GaN, GaP, GaAs, GaSb, AlN, AlP, AlAs, AlSb, InN, InP, InAs, InSb, or a combination thereof; a ternary element compound such as GaNP, GaNAs, GaNSb, GaPAs, GaPSb, AlNP, AlNAs, AlNSb, AlPAs, AlPSb, InNP, InNAs, InNSb, InPAs, InPSb, or a combination thereof; a quaternary element compound such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, or a combination thereof; or a combination thereof. The Group III-V compound may further include a Group II metal (e.g., InZnP).

The Group IV-VI compound may include a binary element compound such as SnS, SnSe, SnTe, PbS, PbSe, PbTe, or a combination thereof; a ternary element compound such as SnSeS, SnSeTe, SnSTe, PbSeS, PbSeTe, PbSTe, SnPbS, SnPbSe, SnPbTe, or a combination thereof; a quaternary element compound such as SnPbSSe, SnPbSeTe, SnPbSTe, or a combination thereof; or a combination thereof.

Examples of the Group I-III-VI compound may include $CuInSe_2$, $CuInS_2$, CuInGaSe, and CuInGaS, but are not limited thereto. Examples of the Group I-III-VI compound may include a ternary element compound such as AgInS, $AgInS_2$, $AgInSe_2$, AgGaS, $AgGaS_2$, $AgGaSe_2$, CuInS, $CuInS_2$, $CuInSe_2$, $CuGaS_2$, $CuGaSe_2$, $CuGaO_2$, $AgGaO_2$, $AgAlO_2$ or a combination thereof; a quaternary element compound such as $AgInGaS_2$, $AgInGaSe_2$; or a combination thereof.

Examples of the Group I-II-IV-VI compound may be CuZnSnSe, and CuZnSnS, but are not limited thereto.

The Group IV element or compound may include a single element such as Si, Ge, or a combination thereof; a binary element compound such as SiC, SiGe, or a combination thereof; or a combination thereof.

Each element included in a multi-element compound such as a binary element compound, a ternary element compound, or a quaternary element compound may be present in the particle at a uniform concentration or at a non-uniform concentration. For example, the chemical formula described above means the types of elements included in the compound, and the ratio among the elements in the compound may be different. For example, the chemical formula "$AgInGaS_2$" may include $AgIn_xGa_{1-x}S_2$ (wherein x is a real number of greater than 0 to less than 1), but is not limited thereto.

In an embodiment, the first semiconductor nanocrystal may include a metal including indium, zinc, or a combination thereof, and a non-metal including phosphorus, selenium, tellurium, sulfur, or a combination thereof. In an embodiment, the second semiconductor nanocrystal may include a metal including indium, zinc, or a combination thereof, and a non-metal element including phosphorus, selenium, tellurium, sulfur, or a combination thereof.

In an embodiment, the first semiconductor nanocrystal may include InP, InZnP, ZnSe, ZnSeS, ZnSeTe, or a combination thereof; the second semiconductor nanocrystal may include ZnSe, ZnSeS, ZnS, ZnTeSe, or a combination thereof. In an embodiment, the shell may include zinc, sulfur, and optionally selenium for example in the outermost layer.

In an embodiment, the semiconductor nanoparticle may emit blue or green light and may include a core including ZnSeTe, ZnSe, or a combination thereof, and a shell including a zinc chalcogenide (e.g., ZnS, ZnSe, ZnSeS, or a combination thereof). An amount of sulfur in the shell may increase or decrease in a radial direction (from the core toward the surface), e.g., the amount of sulfur may have a concentration gradient wherein the concentration of sulfur varies radially (e.g., decreases or increases in a direction toward the core).

In an embodiment, the semiconductor nanoparticle may emit red or green light, the core may include InP, InZnP, or a combination thereof, and the shell may include a Group II metal including zinc and a non-metal including sulfur, selenium, or a combination thereof.

In an embodiment, the semiconductor nanoparticle may have a core-shell structure, and on the interface between the core and the shell, an alloyed interlayer may be present or may not be present. The alloyed interlayer layer may include a homogeneous alloy or may have a concentration gradient. The gradient alloy may have a concentration gradient wherein the concentration of an element of the shell varies radially (e.g., decreases or increases in a direction toward the core).

In an embodiment, the shell may have a composition that varies in a radial direction. In an embodiment, the shell may be a multilayered shell including two or more layers. In a multilayered shell, adjacent two layers may have different compositions from each other. In a multilayered shell, a, e.g., at least one, layer may independently include a semiconductor nanocrystal having a single composition. In a multilayered shell, a, e.g., at least one, layer may independently have an alloyed semiconductor nanocrystal. In a multilayered shell, a, e.g., at least one, layer may have a concentration gradient that varies radially in terms of a composition of a semiconductor nanocrystal.

In an embodiment, in the semiconductor nanoparticle having a core-shell structure, a shell material may have a bandgap energy that is greater than that of the core. The materials of the shell may have a bandgap energy that is less than that of the core. In the case of a multilayered shell, the bandgap energy of the outermost layer material of the shell may be greater than the bandgap energies of the core and the inner layer material of the shell (layers that are closer to the core). In the case of a multilayered shell, a semiconductor nanocrystal of each layer is selected to have an appropriate bandgap, thereby effectively exhibiting a quantum confinement effect.

The semiconductor nanoparticle according to an embodiment may include, for example, an organic ligand which is bonded or coordinated to a surface thereof.

An absorption or emission wavelength of the semiconductor nanoparticle may be controlled by adjusting the compositions, the particle size, or a combination thereof, of the semiconductor nanoparticle. The semiconductor nanoparticle included in the light-emitting layer 3, or 30, may emit light of a desired color. The semiconductor nanoparticle may include a blue light-emitting semiconductor nanoparticle, a green light-emitting semiconductor nanoparticle, or a red light-emitting semiconductor nanoparticle. In an embodiment, the light emitting layer may be configured to emit blue light, green light, or red light, and wavelengths of blue light, green light, and red light are as described herein.

In an embodiment, a peak emission wavelength of the semiconductor nanoparticle or a light emission layer (or the light emitted from the electroluminescent device) may be in a wavelength range from ultraviolet to infrared. In an embodiment, the peak emission wavelength of the semiconductor nanoparticle or the light-emitting layer (or the light emitted from the electroluminescent device) may be greater than or equal to about 300 nm, greater than or equal to about 500 nm, greater than or equal to about 510 nm, greater than or equal to about 520 nm, greater than or equal to about 530 nm, greater than or equal to about 540 nm, greater than or equal to about 550 nm, greater than or equal to about 560 nm, greater than or equal to about 570 nm, greater than or equal to about 580 nm, greater than or equal to about 590 nm, greater than or equal to about 600 nm, or greater than or equal to about 610 nm. The peak emission wavelength may be less than or equal to about 900 nm, less than or equal to about 800 nm, less than or equal to about 650 nm, less than or equal to about 640 nm, less than or equal to about 630 nm, less than or equal to about 620 nm, less than or equal to about 610 nm, less than or equal to about 600 nm, less than or equal to about 590 nm, less than or equal to about 580 nm, less than or equal to about 570 nm, less than or equal to about 560 nm, less than or equal to about 550 nm, or less than or equal to about 540 nm. The peak emission wavelength may be from about 500 nm to about 650 nm.

The semiconductor nanoparticle, the light-emitting layer, or the electroluminescent device may emit a green light (for example, on an application of a voltage or irradiation with light) and a peak emission wavelength thereof may be in the range of greater than or equal to about 500 nm (for example, greater than or equal to about 510 nm, or greater than or equal to about 515 nm) and less than or equal to about 560 nm, for example, less than or equal to about 540 nm, or less than or equal to about 530 nm. The semiconductor nanoparticle, the light-emitting layer, or the electroluminescent device may emit a red light (for example, on an application of voltage or irradiation with light), and a peak emission wavelength thereof may be in the range of greater than or equal to about 600 nm, for example, greater than or equal to about 610 nm and less than or equal to about 650 nm, or less than or equal to about 640 nm. The semiconductor nanoparticle, the light-emitting layer, or the electroluminescent device may emit a blue light (for example, on an application of voltage or irradiation with light), and a peak emission wavelength thereof may be greater than or equal to about 430 nm (for example, greater than or equal to about 450 nm, greater than or equal to about 455 nm, greater than or equal to about 460 nm, or greater than or equal to about 465 nm) and less than or equal to about 480 nm (for example, less than or equal to about 475 nm, less than or equal to about 470 nm, or less than or equal to about 465 nm).

In an embodiment, the semiconductor nanoparticle, the light-emitting layer, or the electroluminescent device may exhibit a luminescent spectrum (e.g., photo- or electro- luminescent spectrum) with a relatively narrow full width at half maximum. In an embodiment, in the photo- or electro- luminescent spectrum, the semiconductor nanoparticle, the light-emitting layer, or the electroluminescent device may exhibit a full width at half maximum of less than or equal to about 45 nm, less than or equal to about 44 nm, less than or equal to about 43 nm, less than or equal to about 42 nm, less than or equal to about 41 nm, less than or equal to about 40 nm, less than or equal to about 39 nm, less than or equal to about 38 nm, less than or equal to about 37 nm, less than or equal to about 36 nm, or less than or equal to about 35 nm. The full width at half maximum may be greater than or equal to about 10 nm, greater than or equal to about 15 nm, greater than or equal to about 20 nm, or greater than or equal to about 25 nm.

The semiconductor nanoparticle may exhibit a quantum efficiency (or quantum yield) of greater than or equal to about 10%, for example, greater than or equal to about 30%, greater than or equal to about 50%, greater than or equal to about 60%, greater than or equal to about 70%, greater than or equal to about 80%, greater than or equal to about 90%, or about 100%.

The semiconductor nanoparticle may have a size (or an average size, hereinafter, may be simply referred to as "size") of greater than or equal to about 1 nm and less than or equal to about 100 nm. The size may be a diameter or equivalent diameter converted by assuming a spherical shape from an electron microscope image when not spherical. The size may be calculated from a result of an inductively coupled plasma atomic emission spectroscopy (ICP-AES) analysis. In an embodiment, the semiconductor nanoparticle may have a size of from about 1 nm to about 50 nm, for example, from about 2 nm (or about 3 nm) to about 35 nm. In an embodiment, a size (or an average size) of the semiconductor nanoparticle may be greater than or equal to about 3 nm, greater than or equal to about 4 nm, greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, or greater than or equal to about 12 nm. In an embodiment, a size (or an average size) of the semiconductor nanoparticle may be less than or equal to about 50 nm, less than or equal to about 40 nm, less than or equal to about 30 nm, less than or equal to about 25 nm, less than or equal to about 20 nm, less than or equal to about 19 nm, less than or equal to about 18 nm, less than or equal to about 17 nm, less than or equal to about 16 nm, less than or equal to about 15 nm, less than or equal to about 14 nm, less than or equal to about 13 nm, or less than or equal to about 12 nm.

A shape of the semiconductor nanoparticle or the semiconductor nanostructure is not particularly limited. For example, the shape of the semiconductor nanoparticle may include, but is not limited to, a sphere, a polyhedron, a pyramid, a multi-pod shape, a hexahedron, a cube, a cuboid, a nanotube, a nanorod, a nanowire, or a nanosheet.

The semiconductor nanoparticle may be prepared using an appropriate method. The semiconductor nanoparticle may be prepared for example by a chemical wet method wherein a nanocrystal particle may grow by a reaction between precursors in a reaction system including an organic solvent and an organic ligand. The organic ligand or the organic solvent may coordinate (with or to) a surface of the semiconductor nanocrystal to control the growth thereof.

In an embodiment, for example, the method for preparing the semiconductor nanoparticle having a core/shell structure may include obtaining the core; preparing a first shell precursor solution including a first shell precursor containing a metal (e.g., zinc) and optionally an organic ligand; preparing a second shell precursor containing a non-metal element (e.g., sulfur, selenium, or a combination thereof); and heating the first shell precursor solution to a reaction temperature (e.g., greater than or equal to about 180 °C, greater than or equal to about 200 °C, greater than or equal to about 240 °C, or greater than or equal to about 280 °C to less than or equal to about 360 °C, less than or equal to about 340 °C, or less than or equal to about 320 °C) and adding the core and the second shell precursor (e.g., once or more, or twice or more) to form a shell of a second semiconductor nanocrystal on the first semiconductor nanocrystal core. The method may further include separating the core from a reaction system used for its preparation and dispersing it in an organic solvent to prepare a core dispersion.

In an embodiment, for a shell formation, a solvent and optionally a ligand compound may be heated (or vacuum-treated) under vacuum to a predetermined temperature (e.g., 100 °C or higher), and thereafter, may be heated to a predetermined temperature (e.g., 120 °C or higher) after introducing nitrogen (inert atmosphere) into the reaction flask. Subsequently, the core may be added to the flask, and the shell precursors are sequentially or simultaneously added, and the reaction flask may be heated at a predetermined reaction temperature. One or more shell precursors may be sequentially introduced in different proportions of the mixture during the reaction time to provide a desired compositional gradient of the shell layer.

In the semiconductor nanoparticle of an embodiment, the core may be prepared by an appropriate method. The organic solvent may include a C6-C22 primary amine such as a hexadecylamine, a C6-C22 secondary amine such as dioctylamine, a C6-C40 tertiary amine such as a trioctyl amine, a nitrogen-containing heterocyclic compound such as pyridine, a C6-C40 olefin such as octadecene, a C6-C40 aliphatic hydrocarbon such as hexadecane, octadecane, or squalane, an aromatic hydrocarbon substituted with a C6-C30 alkyl group such as phenyldodecane, phenyltetradecane, or phenyl hexadecane, a primary, secondary, or tertiary phosphine (e.g., trioctyl phosphine ) substituted with at least one (e.g., 1, 2, or 3) C6-C22 alkyl group, a phosphine oxide (e.g. trioctylphosphine oxide) substituted with a (e.g., 1, 2, or 3) C6-C22 alkyl group, a C12-C22 aromatic ether such as phenyl ether or benzyl ether, or a combination thereof.

The organic ligand may coordinate the surfaces of the prepared semiconductor nanoparticles and allow the semiconductor nanoparticles to be well dispersed in the solution. The organic ligand may include RCOOH, $RNH_2$, $R_2NH$, $R_3N$, RSH, $RH_2PO$, $R_2HPO$, $R_sPO$, $RH_2P$, $R_2HP$, $R_3P$, ROH, RCOOR', $RPO(OH)_2$, $R_2POOH$, (wherein R and R' independently include substituted or unsubstituted C1 or more, C6 or more, or C10 or more and C40 or less, C35 or less, or C25 or less aliphatic hydrocarbon group, or substituted or unsubstituted C6-C40 aromatic hydrocarbon group, or a combination thereof), or a combination thereof. The ligands may be used alone or as a mixture of two or more compounds.

Examples of the organic ligand may be a thiol compound such as methane thiol, ethane thiol, propane thiol, butane thiol, pentane thiol, hexane thiol, octane thiol, dodecane thiol, hexadecane thiol, octadecane thiol, benzyl thiol, and the like; amines such as methane amine, ethane amine, propane amine, butane amine, pentyl amine, hexyl amine, octyl amine, nonylamine, decylamine, dodecyl amine, hexadecyl amine, octadecyl amine, dimethyl amine, diethyl amine, dipropyl amine, tributylamine, trioctylamine, and the like; a carboxylic acid compound such as methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, myristic acid, stearic acid, lauric acid, benzoic acid, and the like; a phosphine compound such as methyl phosphine, ethyl phosphine, propyl phosphine, butyl phosphine, pentyl phosphine, octylphosphine, dioctyl phosphine, tributylphosphine, trioctylphosphine, and the like; a phosphine oxide compound thereof such as methyl phosphine oxide, ethyl phosphine oxide, propyl phosphine oxide, butyl phosphine oxide, pentyl phosphine oxide, tributylphosphine oxide, octylphosphine oxide, dioctyl phosphine oxide, trioctylphosphine oxide, and the like; diphenyl phosphine(DPP), triphenyl phosphine compound or an oxide compound thereof; C5-C20 alkyl phosphinic acid such as hexylphosphinic acid, octylphosphinic acid, dodecanephosphinic acid, tetradecanephosphinic acid, hexadecanephosphinic acid, octadecanephosphinic acid; C5-C20 alkyl phosphonic acid; and the like, but is not limited thereof.

The semiconductor nanoparticle may be recovered by a process of pouring a non-solvent into a mixture including the semiconductor nanoparticle and subjecting the mixture to a centrifugation in order to remove excess organic substance that is not coordinated on the surface from them. For example, in an embodiment, after completing the reaction (for the formation of the core or for the formation of the shell), a non-solvent may be added to a reaction mixture and the semiconductor nanoparticle coordinated with the ligand compound may be separated therefrom. The non-solvent may be a polar solvent that is miscible with the solvent used in the core formation reactions, shell formation reaction, or a combination thereof, and is not capable of dispersing the prepared semiconductor nanoparticles. The non-solvent may be selected depending on the solvent used in the reaction and may include, for example, acetone, ethanol, butanol, isopropanol, ethanediol, water, tetrahydrofuran (THF), dimethylsulfoxide (DMSO), diethylether, formaldehyde, acetaldehyde, a solvent having a similar solubility parameter to the foregoing non-solvents, or a combination thereof. The semiconductor nanoparticles may be separated through centrifugation, sedimentation, or chromatography. The separated semiconductor nanoparticles may be washed with a washing solvent, if desired. The washing solvent has no particular limit and may have a similar solubility parameter to that of the ligand and may, for example, include hexane, heptane, octane, chloroform, toluene, benzene, and the like.

The semiconductor nanoparticles of an embodiment may be non-dispersible or insoluble in water, the aforementioned non-solvent, or a combination thereof. The semiconductor nanoparticles of an embodiment may be dispersed in the aforementioned organic solvent. In an embodiment, the aforementioned semiconductor nanoparticles may be dispersed in a substituted or unsubstituted C6-C40 aliphatic hydrocarbon, a substituted or unsubstituted C6-C40 aromatic hydrocarbon, or a combination thereof.

In the electroluminescent device or the display device of an embodiment, a thickness of the light-emitting layer may be appropriately selected. In an embodiment, the light-emitting layer may include a monolayer of nanoparticles. In an embodiment, the light-emitting layer may include one or more, for example, two or more, three or more, or four or more and 20 or less, 10 or less, 9 or less, 8 or less, 7 or less, or 6 or less monolayers of semiconductor nanoparticles. The light-emitting layer may have a thickness of greater than or equal to about 5 nm, for example, greater than or equal to about 10 nm, greater than or equal to about 20 nm, or greater than or equal to about 30 nm and less than or equal to about 200 nm, less than or equal to about 150 nm, less than or equal to about 100 nm, less than or equal to about 90 nm, less than or equal to about 80 nm, less than or equal to about 70 nm, less than or equal to about 60 nm, or less than or equal to about 50 nm. The light-emitting layer may have a thickness of, for example, about 10 nm to about 150 nm, about 20 nm to about 100 nm, or about 30 nm to about 50 nm.

In an embodiment, the disposing (e.g., forming) of the light-emitting layer 3 including the semiconductor nanoparticle may be performed by providing a composition including a semiconductor nanoparticle and an organic solvent and applying or depositing the same on a substrate (e.g., an electrode) or a charge auxiliary layer (e.g., a hole auxiliary layer or electron auxiliary layer) using an appropriate method (e.g., by spin coating, inkjet printing, or the like).

The forming of the light-emitting layer may further include heat-treating the coated or deposited semiconductor nanoparticle layer. The heat-treating (e.g., thermal treatment, or heat treatment) temperature is not particularly limited, and it may be appropriately selected taking into consideration the boiling point of the organic solvent. For example, the heat treatment temperature may be greater than or equal to about 60°C, or greater than or equal to about 70 °C, and less than or equal to about 250 °C, or less than or equal to about 180 °C. A type of the organic solvent for the coating liquid is not particularly limited and may be selected appropriately. In an embodiment, the organic solvent may include a substituted or unsubstituted aliphatic hydrocarbon organic solvent, a substituted or unsubstituted aromatic hydrocarbon solvent, a substituted or unsubstituted alicyclic hydrocarbon solvent, an acetate solvent, or a combination thereof.

In an embodiment, the light-emitting layer may be a single layer or a multi-layered structure having at least two layers. In the multi-layered structure, adjacent layers (e.g., a first light-emitting layer and a second light-emitting layer) may be configured to emit a first light (e.g., green light, blue light, or red light). In the multi-layered structure, adjacent layers (e.g., a first light-emitting layer and a second light-emitting layer) may have the same or different composition, ligands, or a combination thereof. In an embodiment, the (multi-layered) light-emitting layer may have a halogen amount that varies (increase or decrease) in a thickness direction. In an embodiment, in the (multi-layered) light-emitting layer, the amount of the halogen may increase in a direction toward the electron auxiliary layer. In the (multi-layered) light-emitting layer, an amount, or a content of an organic ligand may decrease in the direction toward the electron auxiliary layer. In the (multi-layered) light-emitting layer, the amount, or the content of the organic ligand may increase in the direction toward the electron auxiliary layer.

In an embodiment, the light-emitting layer may include a first light-emitting layer including a first semiconductor nanoparticle and a second light-emitting layer including a second semiconductor nanoparticle, wherein the first semiconductor nanoparticle has a halogen (e.g., chlorine) exchanged surface and the second light-emitting layer has an increased amount of an organic ligand. A halogen (e.g., chlorine) amount and an organic ligand amount of the light-emitting layer may be controlled with an appropriate manner (e.g., a post treatment for the formed layer). In an embodiment, a thin film of the semiconductor nanoparticles having an organic ligand (e.g., having a carboxylic acid group) is formed, which is then treated with a solution including a metal halide (e.g., a zinc halide such as a zinc chloride in alcohol solvent) to control (decrease) an amount of the organic ligand of the semiconductor nanoparticles in the thin film. The treated thin film may have an increased halogen amount, exhibiting, a changed property (e.g., solubility) relative to an organic solvent, and it may be possible to form a layer of semiconductor nanoparticles having a different amount of an organic ligand (e.g., a halogen treated semiconductor nanoparticle or a semiconductor nanoparticle with a ligand having a carboxylic acid group) on the treated thin film, subsequently.

An electron auxiliary layer (including an electron transport layer) 4, or 40, may be disposed on the light-emitting layer 3, or 30, for example, between the light-emitting layer and the second electrode 5, or 50. In the electron auxiliary layer 4, or 40, transporting, injecting, or transporting and injecting of electrons may occur. The electron auxiliary layer 4, or 40, includes an electron transport layer (ETL). The electron auxiliary layer 4, or 40, may further include an electron injection layer, a hole blocking layer, or a combination thereof. The electron injection layer, the hole blocking layer, or a combination thereof, may be disposed between the electron transport layer and the second electrode, but it is not limited thereto. The hole blocking layer may be disposed between the electron transport layer and the light emitting layer. The electron transport layer may be adjacent to the light-emitting layer (e.g., disposed directly on the light-emitting layer). In an embodiment, the electron transport layer may be in contact with the light-emitting layer.

The electron transport layer may include a (e.g., plurality of) zinc oxide nanoparticle. The zinc oxide nanoparticle includes magnesium, an alkali metal, and sulfur. In the zinc oxide nanoparticle, a mole ratio of alkali metal to sulfur may be greater than 0:1, or greater than or equal to about 0.01:1 and less than or equal to about 6:1, less than or equal to about 2:1, or less than or equal to about 1:1.

The zinc oxide nanoparticle may further include an alkaline earth metal other than magnesium (for example, calcium, barium, strontium, or a combination thereof), Zr, W, Ti, Y, Al, gallium, indium, tin (Sn), cobalt (Co), vanadium (V), or a combination thereof. The alkali metal may include sodium, potassium, rubidium, cesium, francium, or a combination thereof. The alkali metal may include or may not include lithium. The alkali metal may include lithium, sodium, potassium, or a combination thereof. The alkali metal may include lithium, sodium, potassium, or a combination thereof; and rubidium, cesium, or a combination thereof. The electroluminescent device of an embodiment may exhibit increased electroluminescent properties (e.g., EQE) by having the features described herein.

It has been reported that the electron auxiliary layer based on zinc oxide nanoparticles may provide improved properties in cadmium-based QD-LEDs. However, the present inventors have found that in case of an electroluminescent device configured to emit light of a desired wavelength (e.g., blue light) and including a cadmium-free semiconductor nanoparticle in the light-emitting layer, there are technical limitations in improving electroluminescent properties together with lifespan, even when the device includes an electron auxiliary layer based on a zinc oxide nanoparticle. Without wishing to be bound by any particular theory, it is believed that in a QD-LED having a light-emitting layer including cadmium-free semiconductor nanoparticles (or blue light-emitting semiconductor nanoparticles including a Zn chalcogenide core), a charge imbalance between the holes moving through the hole auxiliary layer (e.g., HTL) and electrons moving through the ETL based on zinc oxide nanoparticles may occur, which may lead to a decrease in the electroluminescent property of the light-emitting device (e.g., a maximum external quantum efficiency or a maximum luminance) or a device degradation.

Surprisingly, the present inventors have found that an electroluminescent device including an electron transport layer containing the zinc oxide nanoparticle described herein may exhibit extended lifespan along with an improved optical property (e.g., an electroluminescent property). The zinc oxide nanoparticle may be synthesized by the method described herein.

The zinc metal oxide nanoparticle included in the electron transport layer may be synthesized by a sol-gel process or a solution-precipitation process in a bottom-up synthesis. Accordingly, the zinc oxide nanoparticle obtained thereby may include an organic material derived from a reagent included in a reaction system, such as a precursor, for example, as a particle surface stabilization ligand, but it may also include a surface defect. Without wishing to be bound by any theory, it is believed that a surface property of the prepared zinc oxide nanoparticle may have an effect on a device performance or its property. For example, a presence of the surface defect may cause, for example, a decrease in an efficiency or a degradation of the electron transport layer.

According to an embodiment, the synthesis of zinc oxide nanoparticle includes contacting a zinc oxide nanoparticle containing magnesium (hereinafter also referred to as a magnesium zinc oxide nanoparticle) with a monomolecular alkali metal sulfide in a medium. The contacting may not require separate heating and may be carried out under an ambient or mild condition, but may be performed under a basic atmosphere (e.g., under a basic environment provided by an organic base such as tetramethylammonium hydroxide (TMAH) or an alkali metal hydroxide). The contacting may allow a polar synthetic environment, making it possible for the resulting nanoparticle to exhibit a desired dispersion property and to provide an electron transport layer via a solution-based coating or inkjet method. Surprisingly, the present inventors have found that the zinc oxide nanoparticle of an embodiment may significantly mitigate interfacial quenching phenomena that may occur otherwise when the electron transport layer is in contact with a semiconductor nanoparticle-based light-emitting layer. In addition, the electron transport property of the electron transport layer containing the zinc oxide nanoparticle of an embodiment may be improved.

Without wishing to be bound by any particular theory, it is believed that a monomolecular alkali metal sulfide may be ionized in a medium into an alkali metal ion and a sulfur ion, which may bind or be adsorbed to a surface of the magnesium zinc oxide nanoparticle (e.g., to a zinc residue or a hydroxyl residue). This (individual) binding (or adsorption) of the alkali metal ion and the sulfur ion may passivate a defect present on the surface of the magnesium zinc oxide particle, thereby bringing a desired change to a surface property and/or an electrical property of the nanoparticle, and improving the properties of the electroluminescent device containing them. The zinc oxide nanoparticle of an embodiment may exhibit the elemental mole ratios described herein, for example, the mole ratio of alkali metal to sulfur, and an electroluminescent device including these in the electron transport layer may exhibit reduced initial voltage and reduced voltage increase (delta voltage) during the device operation. The electroluminescent device according to an embodiment has a high operational stability and may exhibit an improved electroluminescent property (e.g., a higher luminance) and extended lifespan.

In an embodiment, the zinc oxide nanoparticle may be synthesized by a solution-precipitation method. In an embodiment of the method, a basic reducing agent may be added to a medium containing a zinc precursor and a magnesium precursor in a polar solvent to create an alkaline or basic environment, and the zinc precursor may be reduced to an intermediate $Zn(OH)_x$, and thereafter, nucleation and growth of ZnO-based particle may occur through a sequential condensation reaction of $Zn(OH)_x$ and an adsorption/desorption on the surface of the generated ZnO particle. Without wishing to be bound by any theory, the magnesium precursor may contribute to suppressing the occurrence of defects such as oxygen vacancies (Vo) in the ZnO particle. In an embodiment of the method, a predetermined amount of an alkali metal sulfide (e.g., $Na_2S$) may be added to and contacted with a ZnO (i.e., ZnMgO) particle solution containing Mg, allowing Na and S to bind to the surface of the zinc oxide (e.g., ZnMgO) nanoparticle. The addition of the alkali metal sulfide (e.g., $Na_2S$) may change a property of a resulting particle, for example, mitigating a defect issue within the ZnMgO particle. The ETL layer using the zinc oxide nanoparticles according to an embodiment may be applied to a QD-LED (e.g., a blue QD-LED) to improve the operational lifespan and an electroluminescent property of the device.

In an embodiment, the zinc oxide nanoparticle may be synthesized by a method, which includes:
forming a magnesium-containing zinc oxide nanoparticle by mixing a first solution containing a zinc precursor, a magnesium precursor, and a solvent (e.g., a first organic solvent) with a base; and contacting the magnesium-containing zinc oxide nanoparticle with an alkali metal sulfide in a reaction solvent.

The method may include preparing the first solution by dissolving the zinc precursor and the magnesium precursor in the solvent. The base may include an inorganic base, an organic base, or a combination thereof.

The mixing may involve the reaction of the zinc precursor, the magnesium precursor, and the base (e.g., a first base (organic base), a second base (inorganic base), or a combination thereof), thereby forming the magnesium-containing zinc oxide nanoparticle.

The zinc precursor may include an organic compound containing zinc, and the magnesium precursor may include an organic compound containing magnesium.

In an embodiment of the method, the first base may include an organic base containing a C1-C50 (e.g., C1-C12, C2-C9, C3-C8, or C4-C5) organic group (e.g., a C1-C50, C1-C12, C2-C9, C3-C8, or C4-C5 aliphatic hydrocarbon group such as an alkyl group), and the second base may include an inorganic base including an alkali metal.

The first solution may include or may not include a C1-C12 aliphatic amine (e.g., an alkyl amine such as butyl amine), an aromatic amine having a benzene ring, or a combination thereof. The aliphatic/aromatic amine may be a primary amine, a secondary amine, or a tertiary amine. The aliphatic/aromatic amine may include an alcoholic amine. The aliphatic/aromatic amine may be butylamine, ethylamine, hexylamine, hexamethylenediamine, aniline, ethanolamine, or a combination thereof.

The zinc precursor and the magnesium precursor may include a carboxylate moiety (for example, an acetate group).

The zinc precursor may include a zinc carboxylate such as zinc acetate, or the like; zinc acetylacetonate; a zinc halide such as a zinc chloride, a zinc bromide, a zinc iodide, a zinc fluoride, or the like; a zinc nitrate; a zinc oxide; or a combination thereof. The magnesium precursor may include a carboxylate compound (e.g., an acetate compound), an acetylacetonate compound, a halide, a nitride, an oxide, or a combination thereof. In an embodiment, the magnesium precursor may include a magnesium carboxylate (e.g., a magnesium acetate), a magnesium acetylacetonate, a magnesium halide (e.g., a magnesium chloride, a magnesium bromide, a magnesium fluoride, a magnesium iodide), a magnesium nitrate, a magnesium oxide, or a combination thereof.

The (organic) solvent may include a C1-C10 alcohol solvent (for example, methanol, ethanol, propanol, isopropanol, butanol, isobutanol, pentanol, isopentanol, or a combination thereof), a sulfoxide solvent (e.g., a dimethyl sulfoxide), a C3-C15 hydrocarbon solvent (an aliphatic solvent, an aromatic solvent, an alicyclic solvent, or an alicyclic compound obtained from a hydrogen addition to an aromatic hydrocarbon) or a combination thereof. The hydrocarbon solvent may include cyclohexane, hexane, heptane, nonane, octane, or a combination thereof. The solvent may include a first organic solvent. The solvent may include the first organic solvent and a second organic solvent capable of mixing with the first organic solvent and water. The first organic solvent may include an organic sulfur solvent such as dimethyl sulfoxide. The second organic solvent may include a C1-C10 or C2-C5 alcohol (methanol, ethanol, propanol, butanol, pentanol, or a combination thereof).

The first base may include a substituted or unsubstituted C1-C50 (e.g., C2-C40, C3-C30, C4-C25, C5-C20, C6-C15, C7-C14, C8-C12, C9-C11, or a combination thereof) aliphatic hydrocarbon group. The number of aliphatic hydrocarbon group may be 1, 2, 3, or 4. The first base may include a quaternary ammonium compound. The first base may include a tetraalkylammonium hydroxide (e.g., a tetra(C1-C6 alkyl) ammonium hydroxide, such as a tetramethylammonium hydroxide, tetraethylammonium hydroxide a diethyldimethylammonium hydroxide, a dimethyldipropylammonium hydroxide, or a combination thereof).

The second base may include an alkali metal hydroxide (e.g., a lithium hydroxide, a sodium hydroxide, a potassium hydroxide, a cesium hydroxide, a rubidium hydroxide, a francium hydroxide, or a combination thereof).

The second base may include at least one or at least two alkali metal hydroxides. The second base may include or may not include a lithium hydroxide, a sodium hydroxide, or a combination thereof. In an embodiment, the second base may include a potassium hydroxide, a cesium hydroxide, a rubidium hydroxide, or a combination thereof. In an embodiment, the second base may be used alone or may be used together with the first base. The zinc oxide nanoparticle prepared by the method descried herein, for example, may be included in the electroluminescent device (for example in an electron transport layer) to exhibit relatively improved device efficiency (EQE), relatively improved particle dispersibility, or both.

In an embodiment, the first base may be used, and a mole ratio between the first base and the second base (i.e., the first base : the second base) may be from about 1: 0 to about 1:10, from about 1:0.1 to about 1:3, from about 1:0.5 to about 1:2.7, from about 1:0.8 to about 1:1.5, from about 1:0.83 to about 1:1.2, from about 1:0.9 to about 1:1.3, from about 1:1 to about 1:1.25, or a combination thereof.

In an embodiment, a mole ratio of the second base to the first base (the second base : the first base) may be from about 1:0 to about 1:10, from about 1:0.05 to about 1:5, from about 1:0.12 to about 1:4.5, from about 1:0.1 to about 1:3, from about 1:0.5 to about 1:2.7, from about 1:0.65 to about 1:2.5, from about 1:0.8 to about 1:1.5, from about 1:0.8 to about 1:1.3, from about 1:0.9 to about 1:1.27, from about 1:0.95 to about 1:1.2, from about 1:1 to about 1:1.25, from about 1:1.05 to about 1:1.24, or a combination thereof.

In an embodiment, a mole ratio of a sum of the zinc precursor and the magnesium precursor with respect to a sum of the first base and the second base (the sum of metal precursors : the sum of the bases) may be from about 1:0.5 to about 1:5, from about 1:0.6 to about 1:4, from about 1:0.7 to about 1:3, from about 1:0.8 to about 1:2.5, from about 1:0.9 to about 1:2, from about 1:1 to about 1:1.5, from about 1:1.1 to about 1:1.48, from about 1:1.21 to about 1:1.45, from about 1:1.35 to about 1:1.2, or a combination thereof.

The mole ratio between the zinc precursor and the magnesium precursor may be appropriately selected taking into consideration a desired composition of the zinc oxide nanoparticle. In an embodiment, the mole amount of the magnesium precursor may be, per one mole of the zinc precursor, from about 0.1 mole to about 1.5 moles, from about 0.2 mole to about 1 mole, from about 0.3 mole to about 0.9 mole, from about 0.4 mole to about 0.8 mole, from about 0.5 mole to about 0.7 mole, or a combination thereof.

In the method, the first base or the second base may be dissolved in the solvent (e.g., an alcohol solvent) and added. In an embodiment, the first base and the second base may be added separately or as a mixture. The method may include or may not include adding an organic acid (for example, acetic acid) or an inorganic acid to a reaction system before or after the first base is added, or before or after the second base is added.

The temperature and time for the reaction may be appropriately adjusted. The temperature for the reaction may be greater than or equal to about 0°C, for example, greater than or equal to about 10°C, greater than or equal to about 20°C, greater than or equal to about 25°C, greater than or equal to about 30°C, greater than or equal to about 35°C, greater than or equal to about 40°C, or greater than or equal to about 45°C. The temperature may be less than or equal to about 100 °C, less than or equal to about 80 °C, less than or equal to about 70 °C, less than or equal to about 65 °C, less than or equal to about 60 °C, less than or equal to about 55 °C, less than or equal to about 50 °C, or less than or equal to about 42 °C. The time for the reaction may be from about 10 minutes to 300 minutes. The reaction time may be greater than or equal to about 20 minutes, greater than or equal to about 40 minutes, greater than or equal to about 50 minutes, greater than or equal to about 70 minutes, greater than or equal to about 90 minutes, greater than or equal to about 110 minutes, greater than or equal to about 120 minutes, greater than or equal to about 130 minutes, or greater than or equal to about and 140 minutes. The reaction time may be less than or equal to about 280 minutes, less than or equal to about 250 minutes, or less than or equal to about 150 minutes.

In an embodiment of the method, for example, to improve dispersibility of the nanoparticles as prepared, the addition of the base may be performed at a predetermined temperature for example, at room temperature, or at a temperature of about 20°C to about 40°C, or at a temperature of about 25 °C to about 30 °C. In an embodiment of the method, for example, to improve the dispersibility of the prepared particles, the reaction may be performed at a temperature of less than or equal to about 60 °C, for example, from about 20 to about 35 °C.

The magnesium-containing zinc oxide nanoparticle obtained by the reaction or the mixing may exist in a dispersed state in the existing reaction medium or in a fresh reaction medium, where it is contacted with an alkali metal sulfide. In an embodiment, the contact may be carried out in the existing reaction medium, and in this case, the alkali metal sulfide may be added to the reaction solution in which the magnesium-containing zinc oxide nanoparticles were synthesized, without separating the nanoparticles. In an embodiment, the contact may be carried out in a fresh reaction medium, and in this case, the magnesium-containing zinc oxide nanoparticles may be separated as described herein, then re-dispersed in a new solvent (e.g., an organic solvent), and contacted with the alkali metal sulfide. The (existing or fresh) reaction medium may include the organic solvent described herein.

The contact between the magnesium-containing zinc oxide nanoparticle and the alkali metal sulfide may include adding a solution containing the alkali metal sulfide and a solvent (e.g., water or an organic solvent) to the reaction medium. The organic solvent may include the first organic solvent and/or the second organic solvent. Details of the first organic solvent and the second organic solvent are as described herein. In an embodiment, the contact between the alkali metal sulfide and the magnesium-containing zinc oxide nanoparticle may occur in the presence of water. The reaction system in which the contact is performed may include a limited content of water or may not include water. For example, the water content in the reaction system may be less than or equal to about 1 wt%, less than or equal to about 0.5 wt%, less than or equal to about 0.1 wt%, or less than or equal to about 0.05 wt% based on a total weight of the solvent.

The alkali metal sulfide may include a lithium sulfide, a sodium sulfide, a potassium sulfide, a rubidium sulfide, a cesium sulfide, or a combination thereof. The alkali metal sulfide may include a lithium sulfide, a sodium sulfide, a potassium sulfide, or a combination thereof.

An amount of the alkali metal sulfide used during the contact may be, per total 1 mole of zinc and magnesium contained in the magnesium-containing zinc oxide particles (or used in the preparation of the particles), greater than or equal to about 0.001 moles, greater than or equal to about 0.002 moles, greater than or equal to about 0.003 moles, greater than or equal to about 0.004 moles, greater than or equal to about 0.005 moles, greater than or equal to about 0.006 moles, greater than or equal to about 0.007 moles, greater than or equal to about 0.008 moles, greater than or equal to about 0.009 moles, greater than or equal to about 0.01 moles, greater than or equal to about 0.012 moles, greater than or equal to about 0.014 moles, greater than or equal to about 0.016 moles, greater than or equal to about 0.018 moles, greater than or equal to about 0.02 moles, greater than or equal to about 0.022 moles, greater than or equal to about 0.024 moles, greater than or equal to about 0.026 moles, greater than or equal to about 0.028 moles, greater than or equal to about 0.03 moles, greater than or equal to about 0.033 moles, greater than or equal to about 0.035 moles, greater than or equal to about 0.037 moles, greater than or equal to about 0.04 moles, greater than or equal to about 0.043 moles, greater than or equal to about 0.045 moles, greater than or equal to about 0.047 moles, greater than or equal to about 0.049 moles, greater than or equal to about 0.05 moles, greater than or equal to about 0.055 moles, greater than or equal to about 0.06 moles, greater than or equal to about 0.065 moles, greater than or equal to about 0.07 moles, greater than or equal to about 0.075 moles, greater than or equal to about 0.08 moles, greater than or equal to about 0.085 moles, greater than or equal to about 0.09 moles, greater than or equal to about 0.095 moles, greater than or equal to about 0.1 moles, greater than or equal to about 0.11 moles, greater than or equal to about 0.12 moles, greater than or equal to about 0.13 moles, greater than or equal to about 0.14 moles, greater than or equal to about 0.15 moles, greater than or equal to about 0.16 moles, greater than or equal to about 0.17 moles, greater than or equal to about 0.18 moles, greater than or equal to about 0.19 moles, or greater than or equal to about 0.2 moles. The amount of the alkali metal sulfide may be, per total 1 mole of zinc and magnesium contained in the magnesium-containing zinc oxide particles (or used in the preparation of the particles), less than or equal to about 1 moles, less than or equal to about 0.9 moles, less than or equal to about 0.8 moles, less than or equal to about 0.7 moles, less than or equal to about 0.6 moles, less than or equal to about 0.5 moles, less than or equal to about 0.4 moles, less than or equal to about 0.3 moles, less than or equal to about 0.25 moles, less than or equal to about 0.21 moles, less than or equal to about 0.195 moles, less than or equal to about 0.185 moles, less than or equal to about 0.175 moles, less than or equal to about 0.165 moles, less than or equal to about 0.155 moles, less than or equal to about 0.145 moles, less than or equal to about 0.135 moles, less than or equal to about 0.125 moles, less than or equal to about 0.115 moles, or less than or equal to about 0.1 moles.

In an embodiment, the contact between the alkali metal sulfide and the magnesium-containing zinc oxide nanoparticle may be performed in a medium including an alcohol such as ethanol, a dialkyl sulfoxide solvent such as dimethyl sulfoxide, or a combination thereof. The medium may include or may not include water. The medium may be alkaline. The medium may have a pH of greater than or equal to about 7, greater than or equal to about 7.2, greater than or equal to about 7.5, greater than or equal to about 7.7, greater than or equal to about 7.9, or greater than or equal to about 8. The medium may include or may not include ethanolamine. The organic solution of the alkali metal sulfide may include an alcohol such as ethanol, an organic sulfur solvent such as dimethyl sulfoxide, or a combination thereof.

The temperature of the contact may be appropriately selected. The temperature of the contact may be greater than or equal to about 10°C, greater than or equal to about 15°C, greater than or equal to about 20°C, greater than or equal to about 25°C, greater than or equal to about 30°C, greater than or equal to about 35°C, greater than or equal to about 40°C, greater than or equal to about 45°C, greater than or equal to about 50°C, greater than or equal to about 55°C, or greater than or equal to about 60°C. The temperature of the contact may be less than or equal to about 100°C, less than or equal to about 80°C, less than or equal to about 65°C, less than or equal to about 52°C, less than or equal to about 49°C, less than or equal to about 46°C, less than or equal to about 43°C, less than or equal to about 38°C, or less than or equal to about 32°C.

The time of the contact may be appropriately selected. The time of the contact may be greater than or equal to about 1 minute, greater than or equal to about 5 minutes, greater than or equal to about 10 minutes, greater than or equal to about 15 minutes, or greater than or equal to about 20 minutes. The time of the contact may be less than or equal to about 2 hours, less than or equal to about 1 hour, less than or equal to about 45 minutes, or less than or equal to about 30 minutes, but is not limited thereto.

In a medium containing ZnMgO, under the conditions described herein, in case where the alkali metal sulfide (e.g., Na2S) is added, the alkali metal and sulfur may bind to the surface of the ZnMgO particles, respectively, for example, in a form of an ion. Therefore, the zinc oxide nanoparticle of an embodiment may include magnesium, alkali metal, and sulfur, and the zinc oxide nanoparticle may exhibit the features described herein (e.g., mole ratios between the elements in the ZnMgO particle, a reduced defect emission indicating the decreased number of the defects on the ZnMgO particle, a reduction of a QD PL quenching which may be observed on the formation of the interfaces between that quantum dot and the ZnMgO, etc.).

After the contacting, the produced zinc oxide nanoparticle may be separated by an appropriate method. To facilitate the precipitation of the zinc oxide nanoparticle thus prepared, a poor solvent (e.g., an alkyl ester solvent such as ethyl acetate) may be added. The precipitated zinc oxide nanoparticle may undergo a process such as centrifugation. The precipitated zinc oxide nanoparticle may be dispersed in an organic solvent such as ethanol to form a colloidal dispersion.

The obtained zinc oxide nanoparticle may exhibit the properties described herein.

In an embodiment, a mole ratio of magnesium to zinc in the zinc oxide nanoparticle or the electron transport layer may be less than or equal to about 0.5:1, less than or equal to about 0.45:1, less than or equal to about 0.35:1, less than or equal to about 0.3:1, less than or equal to about 0.25:1, or less than or equal to about 0.2:1. The mole ratio of magnesium to zinc may be greater than or equal to about 0.01:1, greater than or equal to about 0.03:1, greater than or equal to about 0.05:1, greater than or equal to about 0.07:1, greater than or equal to about 0.09:1, greater than or equal to about 0.1:1, greater than or equal to about 0.12:1, greater than or equal to about 0.14:1, greater than or equal to about 0.16:1, greater than or equal to about 0.18:1, or greater than or equal to about 0.24:1.

In the zinc oxide nanoparticle or the electron transport layer, a mole ratio of alkali metal (e.g., lithium, sodium, potassium, cesium, rubidium, or a combination thereof) to sulfur (alkali metal:sulfur) may be greater than 0:1, greater than or equal to about 0.001:1, greater than or equal to about 0.003:1, greater than or equal to about 0.005:1, greater than or equal to about 0.007:1, greater than or equal to about 0.008:1, greater than or equal to about 0.01:1, greater than or equal to about 0.03:1, greater than or equal to about 0.05:1, greater than or equal to about 0.07:1, greater than or equal to about 0.09:1, greater than or equal to about 0.1:1, greater than or equal to about 0.12:1, greater than or equal to about 0.14:1, greater than or equal to about 0.16:1, greater than or equal to about 0.18:1, greater than or equal to about 0.2:1, greater than or equal to about 0.22:1, greater than or equal to about 0.24:1, greater than or equal to about 0.26:1, greater than or equal to about 0.28:1, greater than or equal to about 0.3:1, greater than or equal to about 0.32:1, greater than or equal to about 0.34:1, greater than or equal to about 0.36:1, greater than or equal to about 0.38:1, greater than or equal to about 0.4:1, greater than or equal to about 0.41:1, greater than or equal to about 0.42:1, greater than or equal to about 0.43:1, greater than or equal to about 0.44:1, or greater than or equal to about 0.45:1. In the zinc oxide nanoparticle or the electron transport layer, the mole ratio of alkali metal (e.g., lithium, sodium, potassium, cesium, rubidium, or a combination thereof) to sulfur (alkali metal:sulfur) may be less than or equal to about 6:1, less than or equal to about 5:1, less than or equal to about 4:1, less than or equal to about 3.5:1, less than or equal to about 3:1, less than or equal to about 2.5:1, less than or equal to about 2:1, less than or equal to about 1.5:1, less than or equal to about 1:1, less than or equal to about 0.95:1, less than or equal to about 0.9:1, less than or equal to about 0.85:1, less than or equal to about 0.8:1, less than or equal to about 0.75:1, less than or equal to about 0.7:1, less than or equal to about 0.65:1, less than or equal to about 0.6:1, less than or equal to about 0.55:1, less than or equal to about 0.5:1, less than or equal to about 0.45:1, less than or equal to about 0.4:1, or less than or equal to about 0.35:1.

In the zinc oxide nanoparticle or the electron transport layer, a mole ratio of magnesium to sulfur (magnesium:sulfur) may be greater than or equal to about 0.1:1, greater than or equal to about 0.5:1, greater than or equal to about 1:1, greater than or equal to about 1.5:1, greater than or equal to about 1.8:1, greater than or equal to about 2:1, greater than or equal to about 2.1:1, greater than or equal to about 2.3:1, greater than or equal to about 2.5:1, greater than or equal to about 2.7:1, greater than or equal to about 2.9:1, greater than or equal to about 3:1, greater than or equal to about 3.3:1, greater than or equal to about 3.5:1, greater than or equal to about 3.7:1, greater than or equal to about 3.9:1, greater than or equal to about 4:1, greater than or equal to about 4.1:1, greater than or equal to about 4.2:1, greater than or equal to about 4.3:1, greater than or equal to about 4.4:1, or greater than or equal to about 4.5:1. In the zinc oxide nanoparticle or the electron transport layer, the mole ratio of magnesium to sulfur (magnesium:sulfur) may be less than or equal to about 30:1, less than or equal to about 25:1, less than or equal to about 20:1, less than or equal to about 18:1, less than or equal to about 15:1, less than or equal to about 13:1, less than or equal to about 12.5:1, less than or equal to about 11:1, less than or equal to about 10:1, less than or equal to about 9:1, less than or equal to about 8:1, less than or equal to about 7:1, less than or equal to about 6:1, less than or equal to about 5:1, less than or equal to about 4.8:1, less than or equal to about 4.4:1, less than or equal to about 4.1:1, or less than or equal to about 3.8:1.

In the zinc oxide nanoparticle or the electron transport layer, the mole ratio of sulfur to magnesium (sulfur:magnesium) may be greater than or equal to about 0.01:1, greater than or equal to about 0.04:1, greater than or equal to about 0.08:1, greater than or equal to about 0.1:1, greater than or equal to about 0.2:1, greater than or equal to about 0.22:1, greater than or equal to about 0.23:1, greater than or equal to about 0.3:1, or greater than or equal to about 0.4:1. In the zinc oxide nanoparticle or the electron transport layer, the mole ratio of sulfur to magnesium (sulfur:magnesium) may be less than or equal to about 1:1, less than or equal to about 0.5:1, less than or equal to about 0.48:1, or less than or equal to about 0.29:1.

In the zinc oxide nanoparticle or the electron transport layer, the mole ratio of alkali metal (e.g., lithium, sodium, potassium, cesium, rubidium, or a combination thereof) to magnesium (alkali metal:magnesium) may be greater than or equal to about 0.01:1, greater than or equal to about 0.015:1, greater than or equal to about 0.02:1, greater than or equal to about 0.025:1, greater than or equal to about 0.03:1, greater than or equal to about 0.033:1, greater than or equal to about 0.034:1, greater than or equal to about 0.035:1, greater than or equal to about 0.037:1, greater than or equal to about 0.04:1, greater than or equal to about 0.05:1, greater than or equal to about 0.06:1, greater than or equal to about 0.07:1, greater than or equal to about 0.08:1, greater than or equal to about 0.09:1, greater than or equal to about 0.1:1, greater than or equal to about 0.11:1, greater than or equal to about 0.12:1, greater than or equal to about 0.13:1, greater than or equal to about 0.14:1, greater than or equal to about 0.15:1, greater than or equal to about 0.16:1, greater than or equal to about 0.17:1, greater than or equal to about 0.18:1, greater than or equal to about 0.19:1, greater than or equal to about 0.2:1, greater than or equal to about 0.22:1, greater than or equal to about 0.24:1, greater than or equal to about 0.26:1, greater than or equal to about 0.28:1, greater than or equal to about 0.3:1, greater than or equal to about 0.32:1, greater than or equal to about 0.34:1, greater than or equal to about 0.35:1, greater than or equal to about 0.36:1, greater than or equal to about 0.38:1, greater than or equal to about 0.4:1, greater than or equal to about 0.42:1, greater than or equal to about 0.44:1, greater than or equal to about 0.46:1, greater than or equal to about 0.48:1, or greater than or equal to about 0.5:1. In the zinc oxide nanoparticle or the electron transport layer, the mole ratio of alkali metal (e.g., lithium, sodium, potassium, cesium, rubidium, or a combination thereof) to magnesium (alkali metal:magnesium) may be less than or equal to about 2:1, less than or equal to about 1.7:1, less than or equal to about 1.5:1, less than or equal to about 1.3:1, less than or equal to about 1.1:1, less than or equal to about 1:1, less than or equal to about 0.9:1, less than or equal to about 0.77:1, less than or equal to about 0.7:1, less than or equal to about 0.65:1, less than or equal to about 0.6:1, less than or equal to about 0.55:1, less than or equal to about 0.5:1, less than or equal to about 0.45:1, less than or equal to about 0.3:1, less than or equal to about 0.25:1, less than or equal to about 0.2:1, or less than or equal to about 0.15:1.

In the zinc oxide nanoparticle or the electron transport layer, a mole ratio of alkali metal (e.g., lithium, sodium, potassium, cesium, rubidium, or a combination thereof) to zinc (alkali metal:zinc) may be greater than or equal to about 0.001:1, greater than or equal to about 0.0015:1, greater than or equal to about 0.002:1, greater than or equal to about 0.0025:1, greater than or equal to about 0.003:1, greater than or equal to about 0.0033:1, greater than or equal to about 0.0034:1, greater than or equal to about 0.004:1, greater than or equal to about 0.0045:1, greater than or equal to about 0.005:1, greater than or equal to about 0.0055:1, greater than or equal to about 0.006:1, greater than or equal to about 0.0065:1, greater than or equal to about 0.007:1, greater than or equal to about 0.008:1, greater than or equal to about 0.009:1, greater than or equal to about 0.01:1, greater than or equal to about 0.011:1, greater than or equal to about 0.012:1, greater than or equal to about 0.013:1, greater than or equal to about 0.014:1, greater than or equal to about 0.0143:1, greater than or equal to about 0.0145:1, greater than or equal to about 0.015:1, greater than or equal to about 0.016:1, greater than or equal to about 0.017:1, greater than or equal to about 0.018:1, greater than or equal to about 0.019:1, greater than or equal to about 0.02:1, or greater than or equal to about 0.025:1. In the zinc oxide nanoparticle or the electron transport layer, the mole ratio of alkali metal (e.g., lithium, sodium, potassium, cesium, rubidium, or a combination thereof) to zinc (alkali metal:zinc) may be less than or equal to about 0.15:1, less than or equal to about 0.1:1, less than or equal to about 0.09:1, less than or equal to about 0.08:1, less than or equal to about 0.07:1, less than or equal to about 0.06:1, less than or equal to about 0.05:1, less than or equal to about 0.049:1, less than or equal to about 0.045:1, less than or equal to about 0.04:1, less than or equal to about 0.03:1, less than or equal to about 0.025:1, less than or equal to about 0.02:1, less than or equal to about 0.018:1, or less than or equal to about 0.015:1.

In the zinc oxide nanoparticle or the electron transport layer, the mole ratio of sulfur to zinc (sulfur:zinc) may be greater than or equal to about 0.005:1, greater than or equal to about 0.007:1, greater than or equal to about 0.009:1, greater than or equal to about 0.01:1, greater than or equal to about 0.015:1, greater than or equal to about 0.02:1, greater than or equal to about 0.025:1, greater than or equal to about 0.03:1, greater than or equal to about 0.033:1, greater than or equal to about 0.034:1, greater than or equal to about 0.035:1, greater than or equal to about 0.037:1, greater than or equal to about 0.04:1, greater than or equal to about 0.045:1, greater than or equal to about 0.049:1, or greater than or equal to about 0.05:1. In the zinc oxide nanoparticle or the electron transport layer, the mole ratio of sulfur to zinc (sulfur:zinc) may be less than or equal to about 0.2:1, less than or equal to about 0.15:1, less than or equal to about 0.1:1, less than or equal to about 0.09:1, less than or equal to about 0.085:1, less than or equal to about 0.08:1, less than or equal to about 0.075:1, less than or equal to about 0.07:1, less than or equal to about 0.065:1, less than or equal to about 0.06:1, less than or equal to about 0.055:1, or less than or equal to about 0.054:1.

The zinc oxide nanoparticle may exhibit an S2p peak in the range of binding energy greater than or equal to about 160 eV, greater than or equal to about 161 eV, or from greater than or equal to about 162 eV to less than or equal to about 165 eV, less than or equal to about 164 eV, or less than or equal to about 163 eV in the XPS analysis thereof. Without wishing to be bound by any particular theory, it is believed that these peaks are due to a metal sulfide and, as being considered with the increased sulfur content in the mole ratio, it may suggest a zinc-sulfur bonding.

In an embodiment, the zinc oxide nanoparticle may include a higher concentration of alkali metal on an outer side of the particle compared to an inner side. In an embodiment, the zinc oxide nanoparticle may have a core-shell structure including a core and an outer layer disposed on the core. The zinc oxide nanoparticle or the core may include $Zn_{1-x}M_xO$ (where M includes Mg, Ca, Zr, W, Ti, Y, Al, or a combination thereof, and $0 \leq x \leq 0.5$). In the formula $Zn_{1-x}M_xO$, x may be greater than 0, greater than or equal to about 0.01, greater than or equal to about 0.03, greater than or equal to about 0.05, greater than or equal to about 0.07, greater than or equal to about 0.1, greater than or equal to about 0.13, greater than or equal to about 0.15, greater than or equal to about 0.17, greater than or equal to about 0.2, greater than or equal to about 0.23, or greater than or equal to about 0.25. The x may be less than or equal to about 0.47, less than or equal to about 0.45, less than or equal to about 0.43, less than or equal to about 0.4, less than or equal to about 0.37, less than or equal to about 0.35, or less than or equal to about 0.3. In the formula, M may include Mg; and Ca, Zr, W, Ti, Y, Al, or a combination thereof. The outer layer of the zinc oxide nanoparticle may include alkali metal, sulfur, and optionally an organic material. In an embodiment, the alkali metal may be bound inside the zinc oxide nanoparticle or may be bound or adsorbed on the surface of the zinc oxide nanoparticle (or a hydroxy group on the particle surface).

A feature such as the presence of each component in a zinc oxide nanoparticle or the electron transport layer or a feature such as a mole ratio between the components may be determined or measured by an appropriate analysis tool (e.g., by X-ray photoelectron spectroscopy (XPS)), an inductively coupled plasma atomic emission spectroscopy, a scanning or transmission electron microscope energy dispersion spectroscopy, or the like).

The zinc oxide nanoparticle included in the electroluminescent device of an embodiment may exhibit dispersibility desired for subsequent processes and (for example, due to the additional adsorption of an inorganic material such as an alkali metal ion and organic substances), the zinc oxide nanoparticle of an embodiment may have an improved passivation for defects that may otherwise be present on the particle surface. Surprisingly, the inventors have found that the zinc oxide nanoparticle may have a reduce number of particle-derived defects (e.g., surface defects), thereby exhibiting a significantly reduced trap emission around 490 nm or greater, or around 500 nm in photoluminescence spectroscopy (e.g., using incident light of 300 nm). Additionally, the zinc oxide nanoparticle of an embodiment may show a significantly increased electron carrier mobility as it is included in the electron auxiliary layer. Furthermore, the zinc oxide nanoparticle thus produced may contribute to reducing a quenching phenomenon of the photoluminescence of the light-emitting layer that may otherwise occur as the electron transport layer is disposed on and in contact with a semiconductor nanoparticle-based light-emitting layer.

In an electroluminescent device of an embodiment, when being analyzed by UV-Vis absorption spectroscopy, the zinc oxide nanoparticle exhibit a first absorption peak wavelength of greater than or equal to about 285 nm, greater than or equal to about 289 nm, greater than or equal to about 292 nm, or greater than or equal to about 295 nm and less than or equal to about 315 nm, less than or equal to about 312 nm, less than or equal to about 310 nm, less than or equal to about 309 nm, less than or equal to about 308 nm, less than or equal to about 307 nm, less than or equal to about 305 nm, less than or equal to about 302 nm, less than or equal to about 300 nm, less than or equal to about 299 nm, less than or equal to about 298 nm, or less than or equal to about 297 nm.

When the zinc oxide nanoparticle is analyzed by UV-Vis absorption spectroscopy, the UV-Vis absorption spectrum has a valley that is adjacent to the first absorption peak, and a valley depth of the valley, defined by Equation 1, may be greater than or equal to about 0.005, greater than or equal to about 0.01, greater than or equal to about 0.02, greater than or equal to about 0.027, greater than or equal to about 0.03, greater than or equal to about 0.035, greater than or equal to about 0.04, greater than or equal to about 0.045, greater than or equal to about 0.05, greater than or equal to about 0.055, or greater than or equal to about 0.06:

$$1 - (Abs_{valley} / Abs_{first}) = VD \qquad (1)$$

wherein $Abs_{first}$ is an absorbance at a wavelength of the first absorption peak and $Abs_{valley}$ is an absorbance at a lowest point of the valley, and VD is the valley depth.

The valley depth (VD) may be less than or equal to about 0.2, less than or equal to about 0.15, less than or equal to about 0.12, less than or equal to about 0.1, less than or equal to about 0.08, less than or equal to about 0.07, or less than or equal to about 0.06.

In an embodiment, the zinc oxide nanoparticle may exhibit (e.g., have) a bandgap energy of greater than or equal to about 3.6 eV, greater than or equal to about 3.65 eV, greater than or equal to about 3.7 eV, greater than or equal to about 3.75 eV, greater than or equal to about 3.77 eV, greater than or equal to about 3.78 eV, greater than or equal to about 3.79 eV, and less than or equal to about 3.95 eV, less than or equal to about 3.94 eV, less than or equal to about 3.9 eV, less than or equal to about 3.85 eV, less than or equal to about 3.8 eV, less than or equal to about 3.78 eV, less than or equal to about 3.77 eV, less than or equal to about 3.75 eV, or less than or equal to about 3.7 eV. The bandgap energy may be determined by UV-Vis absorption spectroscopy analysis, for example, by X-intercept value of a tangent line of a UV-Vis absorption curve.

In an electroluminescent device of an embodiment, an electron auxiliary layer including a zinc oxide nanoparticle may be disposed between the second electrode and the light emitting layer, and as a voltage of 0 volts to 8 volts is applied to the device thus obtained, a current density at 8 volts during a third sweep may be increased by 1.5 times, 2 times, 2.5 times, 3 times, 3.5 times, 4 times, 4.5 times, 5 times to 10 times compared to a reference device that includes a zinc oxide nanoparticle without alkali metal and sulfur instead of zinc oxide nanoparticles according to an embodiment in the electron transport layer. In an embodiment, the a current density at 8 volts during a third sweep may be greater than or equal to about 45 milliamperes per square centimeter ($mA/cm^2$), greater than or equal to about 50 $mA/cm^2$, greater than or equal to about 60 $mA/cm^2$, greater than or equal to about 70 $mA/cm^2$, greater than or equal to about 80 $mA/cm^2$, greater than or equal to about 90 $mA/cm^2$, greater than or equal to about 100 $mA/cm^2$, greater than or equal to about 105 $mA/cm^2$, greater than or equal to about 110 $mA/cm^2$, greater than or equal to about 115 $mA/cm^2$, greater than or equal to about 120 $mA/cm^2$, greater than or equal to about 125 $mA/cm^2$, or greater than or equal to about 130 $mA/cm^2$ and less than or equal to about 500 $mA/cm^2$, less than or equal to about 400 $mA/cm^2$, less than or equal to about 350 $mA/cm^2$, less than or equal to about 250 $mA/cm^2$, less than or equal to about 200 $mA/cm^2$, less than or equal to about 150 $mA/cm^2$, or less than or equal to about 140 $mA/cm^2$.

In an embodiment, the zinc oxide nanoparticle may exhibit (e.g., have) a dispersibility desired for example in a solution process of the production method of the electroluminescent device. In an embodiment, the zinc oxide nanoparticle may exhibit, as dispersed in an organic solvent (e.g., an alcohol such as ethanol or a glycol-based solvent such as an alkylene glycol, for example, ethylene glycol or propylene glycol, an alkylene glycol acetate such as ethylene glycol monoalkyl ether acetate, propylene glycol monomethyl ether acetate, or the like) and measured by dynamic light scattering analysis, an average particle diameter (may be referred to as a DLS average particle diameter, as well) of greater than or equal to about 4.5 nm, greater than or equal to about 5 nm, greater than or equal to about 5.5 nm, greater than or equal to about 6 nm, greater than or equal to about 6.5 nm, greater than or equal to about 7 nm, or greater than or equal to about 7.5 nm. The DLS average particle diameter of the zinc oxide nanoparticle may be less than or equal to about 500 nm, less than or equal to about 300 nm, less than or equal to about 150 nm, less than or equal to about 100 nm, less than or equal to about 50 nm, less than or equal to about 40 nm, less than or equal to about 30 nm, less than or equal to about 20 nm, less than or equal to about 10 nm, less than or equal to about 9 nm, less than or equal to about 8.5 nm, less than or equal to about 8 nm, less than or equal to about 7.5 nm, or less than or equal to about 7 nm.

In an embodiment, the zinc oxide nanoparticle may have a size or an average size (hereinafter, simply referred to as "size") of greater than or equal to about 1 nm, greater than or equal to about 2 nm, greater than or equal to about 3 nm, greater than or equal to about 3.5 nm, greater than or equal to about 4 nm, greater than or equal to about 4.5 nm, greater than or equal to about 5 nm, greater than or equal to about 5.5 nm, greater than or equal to about 6 nm, greater than or equal to about 6.5 nm, or greater than or equal to about 7 nm. The zinc oxide nanoparticle may have a size of less than or equal to about 50 nm, for example, less than or equal to about 10 nm, less than or equal to about 8 nm, less than or equal to about 7.2 nm, or less than or equal to about 6.2 nm. The size of the zinc oxide nanoparticle may be a diameter or equivalent diameter converted by assuming a spherical shape when not spherical. The size of the zinc oxide nanoparticle may be measured from an electron microscope (e.g., TEM) analysis (e.g., two dimensional TEM image).

In an embodiment, the electron auxiliary layer (e.g., the electron transport layer) including the zinc oxide nanoparticle may be prepared in a solution process. In an embodiment, the electron transport layer may be formed by dispersing the zinc oxide nanoparticle in an organic solvent (e.g., a polar organic solvent, a non-polar organic solvent, or a combination thereof) to obtain a dispersion for forming an electron transport layer and applying the dispersion to form a film. In an embodiment, the dispersion for forming an electron transport layer may be applied on the light emitting layer. The solution process may further include removing the organic solvent from the formed film (e.g., through evaporation or a thermal treatment, or the like). The thermal treatment (i.e., heat treatment) may be conducted at a temperature of greater than or equal to about 50°C, greater than or equal to about 60°C, greater than or equal to about 70°C, or greater than or equal to about 85°C and less than or equal to about 150°C, less than or equal to about 130°C, less than or equal to about 120°C, or less than or equal to about 100°C.

In an embodiment, a thickness of the electron transport layer may be greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, greater than or equal to about 12 nm, greater than or equal to about 13 nm, greater than or equal to about 14 nm, greater than or equal to about 15 nm, greater than or equal to about 16 nm, greater than or equal to about 17 nm, greater than or equal to about 18 nm, greater than or equal to about 19 nm, or greater than or equal to about 20 nm, and less than or equal to about 120 nm, less than or equal to about 110 nm, less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 30 nm, or less than or equal to about 25 nm, but is not limited thereto.

In an embodiment, an electron injection layer may be further disposed between the electron transport layer and the second electrode. The material of the electron injection layer is not particularly limited and may be selected appropriately.

In an embodiment, the electroluminescent device may further include a hole auxiliary layer 2, or 20, between the first electrode 1, or 10, and the light emitting layer 3, or 30. The hole auxiliary layer 2, or 20, may include a hole injection layer, a hole transport layer, an electron blocking layer, or a combination thereof. The hole auxiliary layer 2, or 20, may be a single layer or a multilayer structure in which adjacent layers include different components. (Reference to FIGS. 1 to 3)

The hole auxiliary layer 2, or 20, may have a HOMO energy level that may be matched with the HOMO energy level of the light emitting layer 3, or 30, in order to enhance mobility of holes transferred from the hole auxiliary layer 2, or 20, to the light emitting layer 3, or 30. In an embodiment, the hole auxiliary layer 2, or 20, may include a hole injection layer close to, e.g., adjacent, the first electrode 1, or 10, and a hole transport layer close to, e.g., adjacent, the light emitting layer 3, or 30.

In an embodiment, the material included in the hole auxiliary layer 2, or 20 (e.g., a hole transport layer, a hole injection layer, or an electron blocking layer), is not particularly limited, and may include, for example, poly(9,9-dioctyl-fluorene-co-N-(4-butylphenyl)-diphenylamine) (TFB), polyarylamine, poly(N-vinylcarbazole), poly(3,4-ethylenedioxythiophene) (PEDOT), poly(3,4-ethylenedioxythiophene): polystyrene sulfonate (PEDOTPSS), polyaniline, polypyrrole, N,N,N',N'-tetrakis(4-methoxyphenyl)-benzidine (TPD), 4,4'-bis[N-(1-naphthyl)-N-phenyl-amino]biphenyl ($\alpha$-NPD), m-MTDATA (4,4',4"-Tris[phenyl(m-tolyl)amino]triphenylamine), 4,4',4"-tris(N-carbazolyl)-triphenylamine (TCTA), 1,1-bis [(di-4-tolylamino)phenyl]cyclohexane (TAPC), a p-type metal oxide (e.g., NiO, WOs, MoOs, or the like), a carbon-based material such as graphene oxide, or a combination thereof, but is not limited thereto.

In the hole auxiliary layer, a thickness of each layer may be appropriately selected. For example, the thickness of each layer may be greater than or equal to about 5 nm, greater than or equal to about 10 nm, greater than or equal to about 15 nm, or greater than or equal to about 20 nm and less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 35 nm, or less than or equal to about 30 nm, but is not limited thereto.

A device according to an embodiment may have a structure for example, as shown in FIG. 2. In an embodiment, and referring to FIG. 2, in the device, the anode 10 disposed on the transparent substrate 100 may include a metal oxide-based (i.e., metal oxide-containing) transparent electrode (e.g., an ITO electrode), and the cathode 50 facing the anode 10 may include a conductive metal (e.g., having a relatively low work function, such as Mg, Al, or the like). The hole auxiliary layer 20 (e.g., a hole injection layer such as PEDOT:PSS, or p-type metal oxide, or a hole transport layer such as TFB, or polyvinylcarbazole (PVK)) may be provided between the transparent electrode 10 and the light emitting layer 30. The hole injection layer may be disposed close to the transparent electrode and the hole transport layer may be disposed close to the light emitting layer. The electron auxiliary layer 40 including an electron transport layer and optionally an electron injection layer may be disposed between the light emitting layer 30 and the cathode 50. The details of the electron transport layer may be as described above.

A device according to another embodiment may have an inverted structure. Herein, the second electrode 50 disposed on the transparent substrate 100 may include a metal oxide(e.g., ITO)-based transparent electrode, and the anode 10 facing the cathode 50 may include a metal (e.g., having a relatively high work function, such as Au, Ag, or the like). For example, an electron auxiliary layer 40 (including an electron transport layer and optionally an electron injection layer) may be disposed between the transparent electrode 50 and the light emitting layer 30. The details of the electron transport layer may be as described above. A hole auxiliary layer 20 (e.g., a hole transport layer including TFB, or PVK, or a hole injection layer including MoOs, or other p-type metal oxide) may be disposed between the metal anode 10 and the light emitting layer 30. (See FIG. 3)

The above device may be produced by an appropriate method. For example, the electroluminescent device may be produced by optionally forming a hole auxiliary layer (e.g., by deposition or coating) on a substrate on which a first electrode is formed, forming a light emitting layer including semiconductor nanoparticles (e.g., a pattern of the aforementioned semiconductor nanoparticles), forming an electron auxiliary layer (including an electron transport layer) (e.g., by vapor deposition or coating) on the light emitting layer, and forming a second electrode on the electron auxiliary layer. A method of forming the electrode/hole auxiliary layer/light emitting layer may be appropriately selected and is not particularly limited.

An electroluminescent device of an embodiment may exhibit an improved level of electroluminescent properties (e.g., along with an extended life-span as described above).

In an embodiment, the electroluminescent device may have a maximum external quantum efficiency (EQE) of greater than or equal to about 3%, greater than or equal to about 4%, greater than or equal to about 5%, greater than or equal to about 5.5%, greater than or equal to about 6%, greater than or equal to about 6.5%, greater than or equal to about 7%, greater than or equal to about 7.5%, greater than or equal to about 7.7%, greater than or equal to about 8%, greater than or equal to about 8.5%, greater than or equal to about 9%, greater than or equal to about 9.5%, greater than or equal to about 10%, greater than or equal to about 10.5%, greater than or equal to about 11%, greater than or equal to about 11.5%, greater than or equal to about 12%, greater than or equal to about 12.5%, greater than or equal to about 13%, greater than or equal to about 13.5%, or greater than or equal to about 14%. The maximum external quantum efficiency (EQE) may be less than or equal to about 40%, less than or equal to about 30%, or less than or equal to about 20%.

The electroluminescent device of an embodiment may have a maximum luminance of greater than or equal to about 30,000 candelas per square meter ($cd/m^2$), greater than or equal to about 40,000 $cd/m^2$, greater than or equal to about 60,000 $cd/m^2$, greater than or equal to about 70,000 $cd/m^2$, greater than or equal to about 80,000 $cd/m^2$, greater than or equal to about 90,000 $cd/m^2$, greater than or equal to about 100,000 $cd/m^2$, greater than or equal to about 150,000 $cd/m^2$, greater than or equal to about 200,000 $cd/m^2$, greater than or equal to about 250,000 $cd/m^2$, greater than or equal to about 300,000 $cd/m^2$, greater than or equal to about 310,000 $cd/m^2$, greater than or equal to about 320,000 $cd/m^2$, greater than or equal to about 330,000 $cd/m^2$, greater than or equal to about 340,000 $cd/m^2$, greater than or equal to about 350,000 $cd/m^2$, greater than or equal to about 360,000 $cd/m^2$, greater than or equal to about 370,000 $cd/m^2$, greater than or equal to about 380,000 $cd/m^2$, greater than or equal to about 390,000 $cd/m^2$, greater than or equal to about 400,000 $cd/m^2$, greater than or equal to about 440,000 $cd/m^2$, greater than or equal to about 500,000 $cd/m^2$, or greater than or equal to about 550,000 $cd/m^2$. The maximum luminance may be from about 3000 $cd/m^2$ to about 100,000 $cd/m^2$, from about 50,000 $cd/m^2$ to about 1,000,000 $cd/m^2$, from about 70,000 $cd/m^2$ to at least about 600,000 $cd/m^2$, or a combination thereof.

The electroluminescent device of an embodiment may emit blue light, green light, or red light. The peak emission wavelength of the blue light, the peak emission wavelength of the green light, or the peak emission wavelength of the red light are the same as described herein.

In an embodiment, as measured by driving the device at a predetermined initial luminance (for example, about 650 nit), the electroluminescent device may exhibit a T50 of greater than or equal to about 50 hours, greater than or equal to about 80 hours, greater than or equal to about 100 hours, greater than or equal to about 135 hours, greater than or equal to about 150 hours, greater than or equal to about 160 hours, greater than or equal to about 165 hours, greater than or equal to about 170 hours, greater than or equal to about 175 hours, greater than or equal to about 178 hours, greater than or equal to about 200 hours, greater than or equal to about 250 hours, greater than or equal to about 300 hours, greater than or equal to about 350 hours, greater than or equal to about 400 hours, greater than or equal to about 450 hours, greater than or equal to about 500 hours, greater than or equal to about 550 hours, greater than or equal to about 600 hours, greater than or equal to about 650 hours, or greater than or equal to about 700 hours. The T50 may be from about 275 hours to about 4000 hours, from about 330 hours to about 2000 hours, from about 350 hours to about 1500 hours, from about 420 hours to about 1000 hours, or from about 430 hours to about 900 hours.

In an embodiment, as measured by driving the device at a predetermined initial luminance (for example, about 650 nit), the electroluminescent device may have a T90 of greater than or equal to about 10 hours, greater than or equal to about 20 hours, greater than or equal to about 22 hours, greater than or equal to about 25 hours, greater than or equal to about 30 hours, greater than or equal to about 40 hours, greater than or equal to about 50 hours, greater than or equal to about 60 hours, greater than or equal to about 70 hours, greater than or equal to about 80 hours, greater than or equal to about 90 hours, greater than or equal to about 100 hours, greater than or equal to about 110 hours, greater than or equal to about 120 hours, greater than or equal to about 130 hours, greater than or equal to about 140 hours, greater than or equal to about 150 hours, greater than or equal to about 160 hours, greater than or equal to about 170 hours, greater than or equal to about 180 hours, greater than or equal to about 190 hours, or greater than or equal to about 200 hours. The T90 may be from about 55 hours to about 1500 hours, from about 62 hours to about 1000 hours, from about 75 hours to about 800 hours, from about 82 hours to about 700 hours, or a combination of thereof.

The electroluminescent device may have an initial driving voltage of less than 2.8 volts (e.g., when it starts emitting light or blue light, or when driven at 650 nits), for example, less than or equal to about 2.79 volts, less than or equal to about 2.76 volts, or less than or equal to about 2.75 volts. The initial driving voltage may range from about 1 volt to about 2.79 volts.

The electroluminescent device may exhibit a reduced voltage increase (delta voltage) in a lifetime measurement experiment. In an embodiment, the delta voltage may be less than or equal to about 0.2 volts, or less than or equal to about 0.19 volts at T50. In an embodiment, the value obtained by dividing the delta voltage by T50 may be greater than 0 and less than or equal to about 0.0013, less than or equal to about 0.0012, less than or equal to about 0.0011, or less than or equal to about 0.001.

In an embodiment, a display device includes the electroluminescent device described herein.

The display device may include a first pixel and a second pixel that is configured to emit light different from the light of the first pixel.

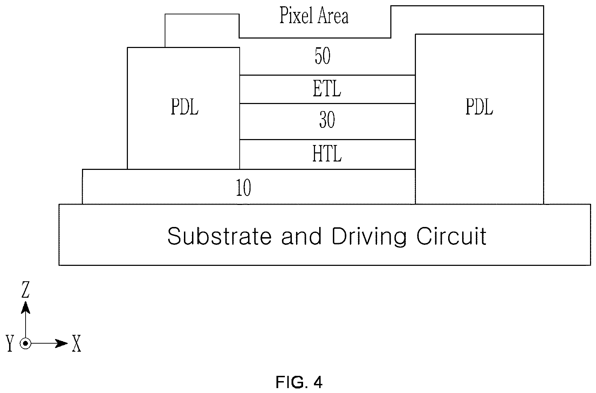

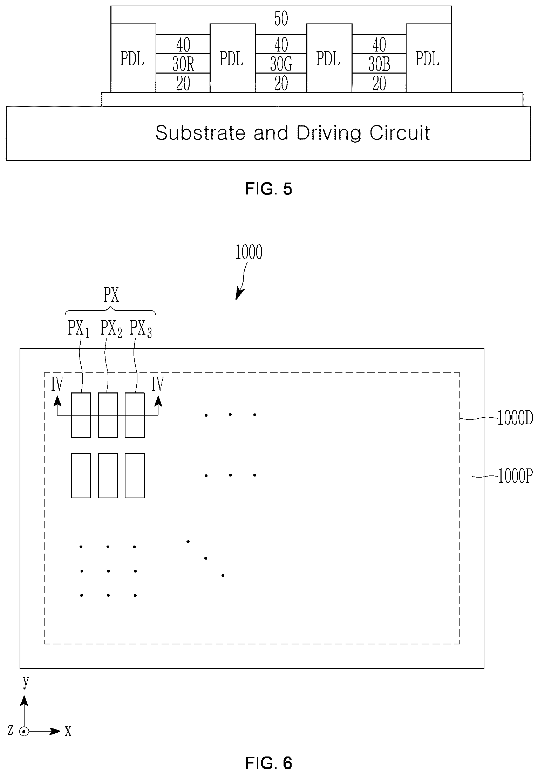

The display device (e.g., a display panel) may include a first pixel and a second pixel configured to emit light of a color different from that of the first pixel. In an embodiment, the first light emitted from the light-emitting layer may be extracted through the second electrode (e.g., in the Z direction) (see Fig. 4 or Fig. 5). In an embodiment, the first light may be extracted through the (transparent) first electrode and optionally through the substrate 100 (see Fig. 3). The light-emitting layer may be disposed within a pixel (or subpixel) in the display device (display panel) as described below (see Fig. 4 or Fig. 5).

Referring to FIG. 6, a display panel 1000 according to an embodiment includes a display area 1000D for displaying an image and a non-display area 1000P disposed around the display area 1000D, in which the binding element may be located.

The display area 1000D may include a plurality of pixels PXs arranged along a row (e.g., x direction) and/or a column (e.g., y direction), and each pixel PX may include a plurality of sub-pixels $PX_1$, $PX_2$, and $PX_3$ displaying different colors. As an example, a configuration in which three sub-pixels $PX_1$, $PX_2$, and $PX_3$ constitute one pixel PX is illustrated, but the configuration is not limited thereto. An additional sub-pixel such as a white sub-pixel may be further included, and one or more sub-pixel displaying the same color may be included. The plurality of pixels PXs may be arranged in, for example, a Bayer matrix, a PenTile matrix, and/or a diamond matrix, but is not limited thereto.

Each of the sub-pixels $PX_1$, $PX_2$, and $PX_3$ may be configured to display a color of three primary colors or a combination of three primary colors, for example, red, green, blue, or a combination thereof (e.g., white light). For example, the first sub-pixel $PX_1$ may be configured to display red, the second sub-pixel $PX_2$ may be configured to display green, and the third sub-pixel $PX_3$ may be configured to display blue.

In the figure, each of the sub-pixels are depicted to have the same size, but the present disclosure is not limited thereto. For example, at least one of the sub-pixels may be larger or smaller, or have a different shape, than another sub-pixel.

In an embodiment, the display panel of an embodiment may include a light emitting panel which may include a lower substrate 110, a buffer layer 111, a thin film transistor TFT, and a light emitting element 180. The display panel may further include a circuit element for switching and/or driving each of the light emitting elements.

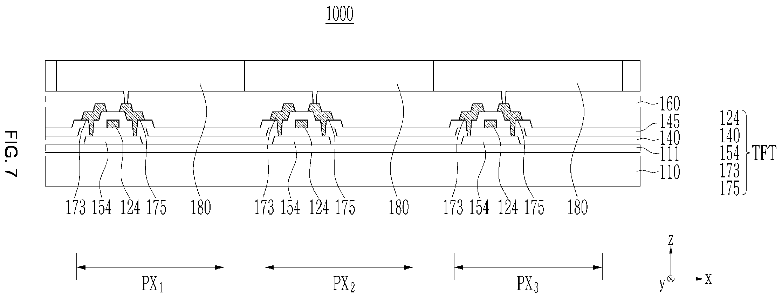

Referring to FIG. 7, in the light emitting panel of an embodiment, the light emitting element 180 may be disposed for each sub-pixel $PX_1$, $PX_2$, and $PX_3$. The light emitting element 180 disposed in each sub-pixel $PX_1$, $PX_2$, and $PX_3$ may be independently driven. The subpixel may include a blue subpixel, red subpixel, or a green subpixel. At least one of the light emitting element 180 may be an electroluminescent element according to an embodiment described herein.

Details of the substrate are the same as described herein. The buffer layer 111 may include an organic material, an inorganic material, or an organic-inorganic material. The buffer layer 111 may include, for example, an oxide, a nitride, or an oxynitride, and may include, for example, silicon oxide, silicon nitride, silicon oxynitride, or a combination thereof, but is not limited thereto. The buffer layer 111 may be one layer or two or more layers and may cover a portion of or the entire surface of the lower substrate 110. The buffer layer 111 may be omitted.

The thin film transistor TFT may be a three terminal element for switching and/or driving the light emitting element 180, and one or two or more may be included for each sub-pixel. The thin film transistor TFT may include a gate electrode 124, a semiconductor layer 154 overlapped with the gate electrode 124, a gate insulating layer 140 between the gate electrode 124 and the semiconductor layer 154, and a source electrode 173 and a drain electrode 175 electrically connected to the semiconductor layer 154. A coplanar top gate structure is shown as an example, but the structure is not limited thereto and may have various structures.

The gate electrode 124 is electrically connected to a gate line (not shown), and may include, for example, a low-resistance metal such as aluminum (Al), molybdenum (Mo), copper (Cu), titanium (Ti), silver (Ag), gold (Au), an alloy thereof, or a combination thereof, but is not limited thereto.

The semiconductor layer 154 may be an inorganic semiconductor such as amorphous silicon, polycrystalline silicon, or oxide semiconductor; an organic semiconductor; an organic-inorganic semiconductor; or a combination thereof. For example, the semiconductor layer 154 may include an oxide semiconductor including at least one of indium (In), zinc (Zn), tin (Sn), and gallium (Ga), and the oxide semiconductor may include, for example, indium-gallium-zinc oxide, zinc-tin oxide, or a combination thereof, but they are not limited thereto. The semiconductor layer 154 may include a channel region and doped regions disposed on both sides of the channel region and electrically connected to the source electrode 173 and the drain electrode 175, respectively.

The gate insulating layer 140 may include an organic material, an inorganic material, or an organic-inorganic material, and may include, for example, an oxide, a nitride, or an oxynitride, and may include, for example, silicon oxide, silicon nitride, silicon oxynitride, or a combination thereof, but is not limited thereto. In the drawing, an example in which the gate insulating layer 140 is formed on the entire surface of the lower substrate 110 is illustrated, but the present disclosure is not limited thereto and may be selectively formed between the gate electrode 124 and the semiconductor layer 154. The gate insulating layer 140 may be formed of one or two or more layers.

The source electrode 173 and the drain electrode 175 may include, for example, a low-resistance metal such as aluminum (Al), molybdenum (Mo), copper (Cu), titanium (Ti), silver (Ag), gold (Au), an alloy thereof, or a combination thereof, but are not limited thereto. The source electrode 173 and the drain electrode 175 may be electrically connected to the doped regions of the semiconductor layer 154, respectively. The source electrode 173 is electrically connected to a data line (not shown), and the drain electrode 175 is electrically connected to a light emitting element 180.

An interlayer insulating layer 145 is additionally formed between the gate electrode 124 and the source/drain electrodes 173 and 175. The interlayer insulating layer 145 may include an organic material, an inorganic material, or an organic-inorganic material, for example, oxide, nitride, or oxynitride, for example, silicon oxide, silicon nitride, silicon oxynitride, or a combination thereof, but is not limited thereto. The interlayer insulating layer 145 may be formed of one or two or more layers.

A protective layer 160 is formed on the thin film transistor TFT. The protective layer 160 may be, for example, a passivation layer. The protective layer 160 may include an organic material, an inorganic material, or an organic-inorganic material, for example, polyacrylic, polyimide, polyamide, poly(amide-imide), or a combination thereof, but is not limited thereto. The protective layer 160 may be formed of one or two or three or more layers.

In an embodiment, one of the first electrode 1, 10 and the second electrode 5, 50, may be a pixel electrode linked to the TFT and the other of them may be a common electrode.

In an embodiment, the light emitting device or the display device including the same may be used in a top emission type, a bottom emission type, a dual emission type, or a combination thereof.

In an embodiment, the first electrode 1, 10 may be a light transmitting electrode and the second electrode 5, 50 may be a reflective electrode, and the display panel may be a bottom emission type display panel that emits light toward the first electrode 10 and the lower substrate 110, if present. In an embodiment, the first electrode 1, 10 may be a reflective electrode and the second electrode 5, 50 may be a light transmitting electrode, and the display panel may be a top emission type display panel that emits light to the opposite side of the first electrode 10 and the lower substrate 110 if present. In an embodiment, both the first electrode and the second electrode may be translucent electrodes, and the display panel 1000 may be a both side emission type display panel that emits light on the substrate side and on the opposite side of the substrate.

The display device or an electronic apparatus may include (or may be) a television, a virtual reality/augmented reality (VR/AR), a handheld terminal, a monitor, a notebook computer, an electronic display board, a camera, or a part for an automatic, e.g., autonomous, vehicle, or the like.

Specific examples are described below. However, the examples described below are only for specifically illustrating or explaining the disclosure, and the scope of the disclosure is not limited thereto.

Examples

1. Photoluminescence (PL) Analysis and TRPL Analysis

Photoluminescence spectroscopy was performed at room temperature with an excitation wavelength of 300 nm using a Hitachi F-7000 spectrophotometer. Time-resolved photoluminescence (TR-PL) spectrum analysis was made using a Microtime100 time-resolved confocal microscope (Picoquant).

2. ICP-AES Analysis

Inductively Coupled Plasma Atomic Emission Spectroscopy (ICP-AES) was performed using a Shimadzu ICPS-8100.

3. UV-Vis Spectroscopy analysis

The UV spectroscopy analysis was performed using a Shimadzu UV-2600 spectrophotometer to obtain UV-Visible absorption spectra. The bandgap energy (eV) may be calculated from the X-intercept wavelength (nm) of the obtained UV-Visible absorption spectrum using the following equation: Bandgap energy (eV) = 1240(nm) / X-intercept wavelength (nm).

4. Electroluminescence Measurement

A current according to an applied voltage is measured with a Keithley 2635B source meter, and a CS2000 spectrometer is used to measure electroluminescent properties (e.g., luminance and EQE) of a light-emitting device.

5. Lifespan Characteristics

T50: As the device is started to be driven at a predetermined luminance (e.g., 650 nit or 146 nit), a time taken for a luminance of a given device to decrease to 50% of its initial luminance is measured.

T90: As the device is started to be driven at a predetermined luminance (e.g., 650 nit or 146 nit), a time taken for a luminance of a given device to decrease to 90% of its initial luminance is measured.

The following syntheses is performed under an inert gas atmosphere (e.g., under nitrogen) unless otherwise specified. A precursor content is provided as a molar content, unless otherwise specified.

Reference Example 1:

Two moles per liter (M) of a Se/trioctylphosphine (TOP) stock solution, 1M of a S/TOP stock solution, and 0.1M of a Te/TOP stock solution were prepared by dispersing selenium (Se), sulfur (S), and tellurium (Te) in trioctylphosphine (TOP), respectively. In a reactor containing trioctylamine, 0.125 millimoles (mmol) of zinc acetate was added to the reactor with oleic acid and heated at 120 °C under vacuum. After 1 hour, nitrogen was introduced into the reactor.

The reactor was heated to 240 °C, and the Se/TOP stock solution and the Te/TOP stock solution in a Te:Se mole ratio of 1:15 were rapidly added to, e.g., injected into, the reactor. When the reaction was complete, the reaction mixture rapidly cooled to room temperature, and acetone was added to facilitate formation of a precipitate. The mixture (suspension) was centrifuged to separate the solids, and then the solids were dispersed in toluene, obtaining a ZnSeTe core (dispersion in toluene).

Next, 1.8 mmol of zinc acetate were added together with oleic acid to a flask containing trioctylamine and the prepared mixture was heated at 120 °C under vacuum for 10 minutes. Nitrogen ($N_2$) was then introduced into the reactor, and the reactor was heated to 220 °C. The prepared ZnTeSe core particle dispersion was added quickly to the reactor, and the Se/TOP stock solution and the S/TOP stock solution were also added to the reactor at a mole ratio between Se and S of about 1:2, and the reactor temperature was raised to about 280 °C. After 2 hours, the reaction was complete, and the reactor was cooled to room temperature and ethanol was added to facilitate precipitation of the semiconductor nanoparticles, which were separated by centrifuge. The separated nanoparticle was dispersed in toluene.

The prepared semiconductor nanoparticles emitted blue light of about 460 nanometers (nm).

Preparation Example 1

Tetramethylammonium hydroxide was dissolved in ethanol to prepare a base solution(Concentration of TMAH: 0.55M). Sodium sulfide was dissolved in dimethyl sulfoxide to prepare an alkali metal sulfide solution(Concentration of $Na_2S$: 0.1M).

Zinc acetate dihydrate (powder) and magnesium acetate tetrahydrate (powder) were added to a flask containing dimethyl sulfoxide and dissolved, then the base solution was added and stirred at room temperature for 60 minutes. The alkali metal sulfide solution was added to the reaction solution and stirred again for 30 minutes.

After the stirring, ethyl acetate was added to the reaction solution to facilitate precipitation, and the formed precipitate was centrifuged to obtain particles. The obtained particles were washed more than twice with ethyl acetate to obtain zinc magnesium oxide nanoparticles. The obtained nanoparticles were re-dispersed in ethanol and analyzed using a transmission electron microscope. As a result, the average size of the nanoparticles was found to be approximately 3-6 nm. The molar ratio between the magnesium precursor and the zinc precursor was 0.15:0.85. The amount of sodium sulfide used was 2% based on the total moles of the magnesium precursor and the zinc precursor.

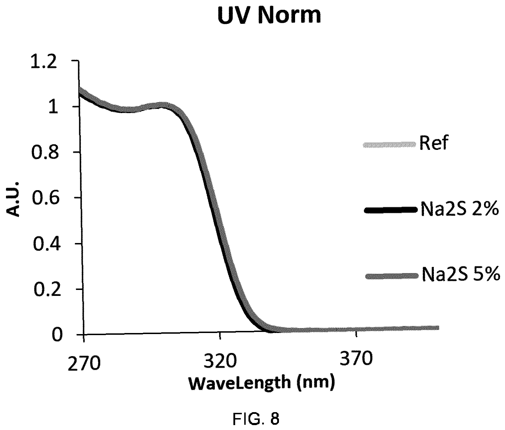

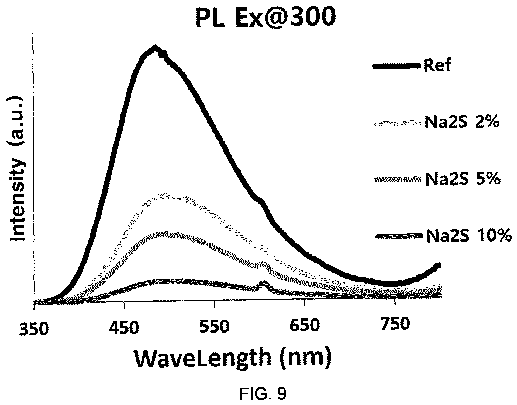

An ICP analysis, a UV-Vis absorption spectroscopy analysis, and a photoluminescence spectroscopy analysis were performed on the obtained nanoparticles, and the results were summarized in Table 1, Table 2, and Figure 8 and Figure 9.

Preparation Example 2

A zinc oxide nanoparticle was prepared in the same manner as Preparation Example 1, except that the amount of sodium sulfide used was 5% based on the total moles of the magnesium precursor and the zinc precursor. The average size of the nanoparticles was found to be approximately 3-6 nm.

An ICP analysis, a UV-Vis absorption spectroscopy analysis, and a photoluminescence spectroscopy analysis were performed on the obtained nanoparticles, and the results were summarized in Table 1, Table 2, and Figure 8 and Figure 9.

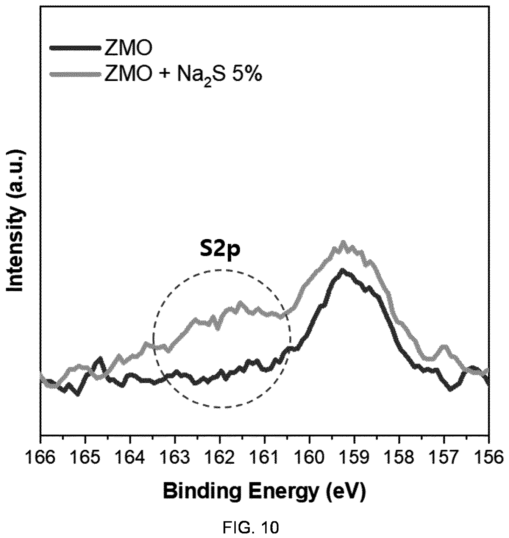

XPS analysis was performed on the obtained nanoparticles, and the results are shown in Figure 10.

Preparation Example 3

A zinc oxide nanoparticle was prepared in the same manner as Preparation Example 1, except that the amount of sodium sulfide used was 10% based on the total moles of the magnesium precursor and the zinc precursor. The average size of the nanoparticles was found to be approximately 3-6 nm.

An ICP analysis and a photoluminescence spectroscopy analysis were performed on the obtained nanoparticles, and the results were summarized in Table 1.

Comparative Preparation Example 1

A zinc oxide nanoparticle was prepared in the same manner as Preparation Example 1, except that the sodium sulfide solution was not used (i.e., not added and stirred).

An ICP analysis, an UV-Vis absorption spectroscopy analysis, and a photoluminescence spectroscopy analysis were performed on the obtained nanoparticles, and the results were summarized in Table 1, Table 2, and Figure 8 and Figure 9.

XPS analysis was performed on the obtained nanoparticles, and the results are shown in Figure 10.

Table 1

|  | Zn | Mg | S | Na | Na:S | Na:Mg | Mg:S |
|---|---|---|---|---|---|---|---|
| Preparation Example 1 | 0.870 | 0.116 | 0.009 | 0.005 | 0.56:1 | 0.043:1 | 12.89:1 |
| Preparation Example 2 | 0.828 | 0.13 | 0.03 | 0.012 | 0.4:1 | 0.092:1 | 4.33:1 |
| Preparation Example 3 | 0.842 | 0.101 | 0.045 | 0.012 | 0.27:1 | 0.119:1 | 2.24:1 |

From the results in Table 1, it was confirmed that the molar ratio of sulfur and alkali metal increased in the nanoparticles of the Preparation examples. From the results in Figure 10, it was confirmed that the nanoparticles of Preparation Example 2 showed an S2p peak, whereas the nanoparticles of the Comparative Preparation Example 1 did not show a corresponding peak.

Table 2

|  | First absorption peak wavelength (nm) | the X intercept wavelength (nm) | Bandgap energy (eV) |
|---|---|---|---|
| Comp. Preparation Example 1 | 300 | 329.9 | 3.759 |
| Preparation Example 1 | 300 | 329.3 | 3.766 |
| Preparation Example 2 | 299 | 330.7 | 3.750 |

From the results in Table 2 and Figure 8, it was confirmed that there was no substantial changes in particle size or bandgap energy due to the addition of the $Na_2S$ solution.

From the results in Figure 9, it was confirmed that the zinc oxide nanoparticles of Comparative Preparation Example 1 showed trap emission around 500 nm, whereas the zinc oxide nanoparticles of Preparation Example 1, Preparation Example 2, and Preparation Example 3 showed a significant reduction in such trap emission.

Experimental Example 1: Electron only device (EOD) analysis

The semiconductor nanoparticles of Reference Example 1 are dispersed in octane to prepare a semiconductor nanoparticle solution.

The zinc oxide nanoparticles of Preparation Example 2 are dispersed in ethanol to provide a first dispersion for forming ETL.

The zinc oxide nanoparticles of Comparative Preparation Example 1 are dispersed in ethanol to provide a second dispersion for forming ETL.

According to the following procedure, an electron only device (EOD) with a structure of ITO/ZMO/EML/ETL/Al was manufactured.

The second dispersion was spin-coated on a glass substrate deposited with an ITO electrode (anode) and then, heat-treated at 80 °C for 30 minutes, forming an electron auxiliary layer (ETL1, thickness: 20 nm).

On the electron auxiliary layer, the semiconductor nanoparticle solution was spin-coated, forming a light emitting layer having a thickness of about 20 nm. On the light emitting layer, the first dispersion and the second dispersion was used to form an electron transport layer (ETL2, thickness: 30 nm), respectively, and then, an Al electrode was deposited thereon.

A current density (mA/cm$^2$) is measured with a change in voltage, increasing (forward scan) and decreasing (backward scan) within a range of 0 to 8 V between the ITO electrode and the Al electrode, and the results are shown in Table 3.

Table 3

|  | Zinc oxide nanoparticle in ETL 1 | Zinc oxide nanoparticle in ETL 2 | In 3$^{rd}$ sweep, current density at 8V (mA/cm$^2$) |
|---|---|---|---|
| EOD 1 | Comparative Preparation Example 1 | Comparative Preparation Example 1 | 43 |
| EOD 2 | Comparative Preparation Example 1 | Preparation Example 2 | 121 |

From the results in Table 3, it was confirmed that the electron transport layer (ETL2) based on the zinc oxide nanoparticles prepared in Preparation Example 2 exhibited significantly higher current density compared to the device containing the nanoparticles of the Comparative Preparation Example 1.

Without wishing to be bound by any particular theory, these results suggest that the nanoparticles of Preparation Example 2 may exhibit increased electron mobility compared to the particles of Comparative Preparation Example 1, the trap sites of the particles of Preparation Example 2 may be passivated, and electron transport therein may become more facilitated.

Production of Electroluminescent Device

Example 1

A semiconductor nanoparticle solution prepared by dispersing the semiconductor nanoparticles prepared in Reference Example 1 in octane was prepared. An ETL dispersion was prepared by dispersing the zinc oxide nanoparticles prepared in Preparation Example 1 in ethanol.

An electroluminescent device (ITO/PEDOT:PSS (35 nm)/TFB (25 nm)/QD light-emitting layer (20 nm)/ETL (20 nm)/Al (100 nm)) was produced according to the following method.

After surface-treating a glass substrate deposited with ITO with UV-ozone for 15 minutes, a PEDOT:PSS solution (H.C. Starks, Inc.) was spin-coated thereon and heat-treated at 150 °C for 10 minutes under an air atmosphere and then, at 150 °C for 20 to 30 minutes under an N$_2$ atmosphere to form a 35 nm-thick hole injection layer.

On the hole injection layer, a poly[(9,9-dioctylfluorenyl-2,7-diyl-co (4,4'-(N-4-butylphenyl)diphenylamine] solution (TFB) (Sumitomo Corp.) was spin-coated and heat-treated at 150 °C for 30 minutes, forming a 25 nm-thick hole transport layer.

On the hole transport layer, the semiconductor nanoparticle solution was spin-coated to form a 20 nm-thick light-emitting layer.

On the light-emitting layer, the ETL dispersion was spin-coated and heat-treated at 80 °C for 30 minutes, forming an electron transport layer (thickness: 20 nm).

On the obtained electron transport layer, aluminum (Al) was vacuum-deposited to be 100 nm thick, forming a second electrode and thus producing an electroluminescent device.

Electroluminescent properties and a life-span of the produced electroluminescent device were measured and some of the results are shown in Table 4. The T50 measured with an initial luminance of 146 nit of the electroluminescent device was about 2247 hours and the EQE at 146 nit was about 7%. The T90 of the device is greater than about 26 hours.

Comparative Example 1

An electroluminescent device was manufactured in the same manner as in Example 1 except that an ETL dispersion prepared by dispersing the zinc oxide nanoparticles of Comparative Example 1 in ethanol was used.

Electroluminescent properties of the produced electroluminescent device were measured and some of the results are shown in Table 4. The T50 at 146 nit of the electroluminescent device was about 1648 hours and the EQE at 146 nit was about 6%.

Table 4

|  | Max EQE (%) | Max. Luminance (nit) | Relative T90 | Relative T50 | Initial voltage | Delta Voltage /T50 |
|---|---|---|---|---|---|---|
| Example 1 | 14 | about 120000 | 120% | 132% | 2.75 volt | 0.001 |

(continued)

|  | Max EQE (%) | Max. Luminance (nit) | Relative T90 | Relative T50 | Initial voltage | Delta Voltage /T50 |
|---|---|---|---|---|---|---|
| Comp. Example 1 | about 9 | 96000 | 100% | 100% | 2.8 volt | 0.0013 |

Relative T90 (%): [T90 (hour) of the device / T90 (hour) of Comparative Example 1] x 100
Relative T50 (%): [T50 (hour) of the device / T50 (hour) of Comparative Example 1] x 100
Delta Voltage / T50: a value obtained by dividing the increase in driving voltage during the lifetime measurement at 650 nits with the T50

From the results in Table 4, it was confirmed that the device of Example 1 exhibited significantly improved electroluminescent properties and extended lifetime compared to the device of Comparative Example 1. It was also confirmed that the initial driving voltage was lower and the increase in voltage over time was reduced.

Without wishing to be bound by any theory, it is believed that the defect passivation of the zinc oxide nanoparticles included in the electron transport layer reduces charge accumulation, enabling it to function as a stable electron transport layer. Additionally, since the electrical conductivity of the ETL including the same may be more readily controlled, whereby electron/hole balancing according to the device structure may become possible. Furthermore, it is possible to provide a high-brightness, long-lifetime device without the tradeoff between EQE and lifetime. The zinc oxide nanoparticles of an embodiment may also be utilized in an inkjet process.

Experimental Example 2: PL Quenching and TRPL Analysis

A semiconductor nanoparticle solution was prepared by dispersing the semiconductor nanoparticles prepared in Reference Example 1 in octane. ETL dispersion 1 and ETL dispersion 2 were prepared by dispersing the zinc oxide nanoparticles prepared in Preparation Example 1 or Comparative Preparation Example 1 in ethanol, respectively.

On a substrate, the semiconductor nanoparticle solution was spin-coated to form a 20 nm thick light-emitting layer. ETL dispersion 1 or ETL dispersion 2 was spin-coated on the light-emitting layer and heat-treated for 30 minutes to form an electron transport layer (thickness: 20 nm), resulting in Stacked Structure 1 and Stacked Structure 2, respectively.

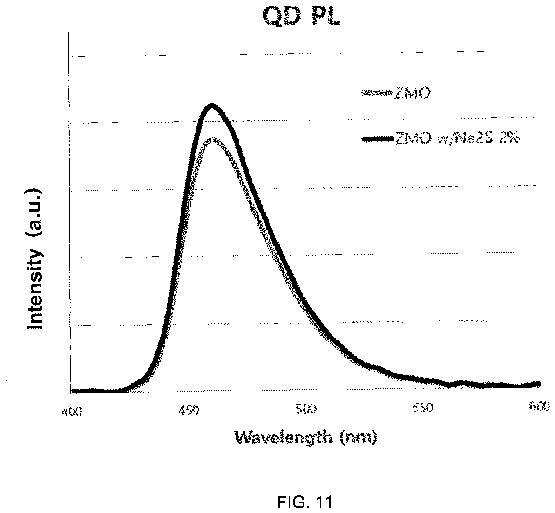

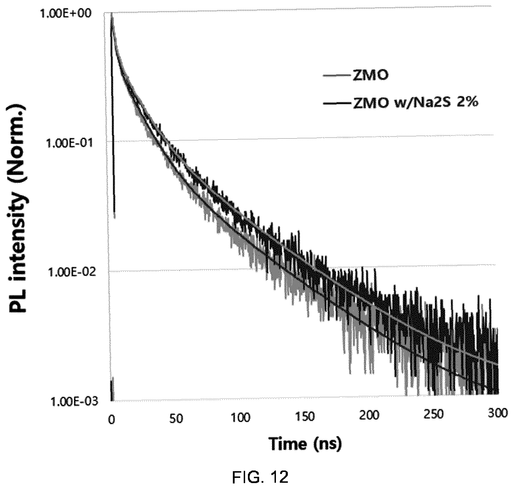

Photoluminescence spectroscopy and time-resolved photoluminescence spectroscopy (TRPL) were performed on the prepared Stacked Structures 1 and 2, and the results were summarized in Figures 11 and 12 and Table 5.

Table 5

|  | Average lifetime (tau average) |
|---|---|
| Stacked structure 1 | 15 |
| Stacked structure 2 | 12 |

From the results in Figure 11, it was confirmed that Stacked Structure 1, which has an electron transport layer containing the zinc oxide nanoparticles of Preparation Example 1, exhibited approximately 12% higher semiconductor nanoparticle (QD) emission intensity compared to Stacked Structure 2, which has an electron transport layer containing the zinc oxide nanoparticles of Comparative Preparation Example 1. This suggests that the PL quenching phenomenon of QDs at the QD/ETL interface was reduced in Stacked Structure 1. From the results in Figure 12, it was confirmed that the lifetime of the semiconductor nanoparticles (QDs) increased in Stacked Structure 1.

While this disclosure has been described in connection with what is presently considered to be practical embodiments, it is to be understood that the invention is not limited to the disclosed embodiments. On the contrary, it is intended to cover various modifications and equivalent arrangements included within the scope of the appended claims.

**Claims**

1. An electroluminescent device comprising:

a first electrode and a second electrode spaced apart from each other;
a light-emitting layer disposed between the first electrode and the second electrode; and
an electron transport layer disposed between the light-emitting layer and the second electrode,
wherein the light-emitting layer comprises a semiconductor nanoparticle,

wherein the electron transport layer comprises a zinc oxide nanoparticle,

wherein the zinc oxide nanoparticle has a size of greater than or equal to 1 nanometer and less than or equal to 15 nanometers, and

wherein the zinc oxide nanoparticle further comprises magnesium, an alkali metal, and sulfur.

2. The electroluminescent device of claim 1, wherein in the zinc oxide nanoparticle, a mole ratio of alkali metal to sulfur (alkali metal:sulfur) is greater than or equal to 0.01:1 and less than or equal to 3:1.

3. The electroluminescent device of claim 1 or 2, wherein the alkali metal comprises lithium, sodium, potassium, rubidium, cesium, or combinations thereof.

4. The electroluminescent device of any preceding claim, wherein the alkali metal comprises lithium, sodium, potassium, or combinations thereof; and optionally potassium, rubidium, cesium, or combinations thereof.

5. The electroluminescent device of any preceding claim, wherein in the zinc oxide nanoparticle, a mole ratio of alkali metal to sulfur (alkali metal:sulfur) is greater than or equal to 0.03:1 and less than or equal to 0.9:1.

6. The electroluminescent device of any preceding claim, wherein in the zinc oxide nanoparticle, a mole ratio of magnesium to sulfur (magnesium:sulfur) is greater than or equal to 0.1:1 and less than or equal to 30:1, preferably greater than or equal to 2:1 and less than or equal to 15:1.

7. The electroluminescent device of any preceding claim, wherein in the zinc oxide nanoparticle,

a mole ratio of alkali metal to magnesium (alkali metal:Mg) is greater than or equal to 0.03:1 and less than or equal to 0.5:1; and/or

a mole ratio of alkali metal to zinc (alkali metal:Zn) is greater than or equal to 0.002:1 and less than or equal to 0.1:1.

8. The electroluminescent device of any preceding claim, wherein in the zinc oxide nanoparticle,

a mole ratio of alkali metal to magnesium (alkali metal:Mg) is greater than or equal to 0.08:1 and less than or equal to 0.4:1; and/or

a mole ratio of alkali metal to zinc (alkali metal:Zn) is greater than or equal to 0.005:1 and less than or equal to 0.05:1.

9. The electroluminescent device of any preceding claim, wherein the zinc oxide nanoparticle shows an S2p peak in the range of binding energy that is from 160 eV to 164 eV in an X-ray photoelectron spectroscopy analysis.

10. The electroluminescent device of any preceding claim, wherein the semiconductor nanoparticle does not contain cadmium.

11. The electroluminescent device of any preceding claim,

wherein the electroluminescent device emits blue light when a voltage is applied; and wherein

the electroluminescent device has a maximum external quantum efficiency of greater than or equal to 10 percent and less than or equal to 40 percent; and/or

the electroluminescent device shows a maximum luminance of greater than or equal to 100,000 candelas per square meter and less than or equal to 500,000 candelas per square meter; and/or

wherein the electroluminescent device exhibits a T90 of greater than or equal to 25 hours and less than or equal to 1000 hours, as measured at an initial luminance of 650 nit.

12. A display device comprising the electroluminescent device of any preceding claim, and preferably wherein the display device is a handheld terminal device, a monitor, a notebook computer, a television, an electronic display board, a camera, or an electronic component for an automatic vehicle.

13. A method of producing an electroluminescent device of any preceding claim, the method comprising:

disposing the light-emitting layer on the first electrode;

applying a composition comprising a zinc oxide nanoparticle on the light-emitting layer to form the electron transport layer; and

disposing the second electrode on the electron transport layer to produce the electroluminescent device,

wherein a preparation of the zinc oxide nanoparticle comprises

contacting a zinc oxide nanoparticle containing magnesium with an alkali metal sulfide in a solvent.

14. The method of claim 13, wherein the solvent comprises a C1-C5 alcohol, a dialkyl sulfoxide solvent, or a combination thereof.

15. The method of claim 13 or 14, wherein an amount of the alkali metal sulfide is greater than or equal to 0.001 moles and less than or equal to 0.2 moles per one mole of a sum of zinc and magnesium; and/or,

wherein the alkali metal sulfide comprises a sodium sulfide, and the method comprises adding a dimethyl sulfoxide solution of the sodium sulfide to the solvent; and/or

wherein the contacting is performed at a temperature of 10°C to 40°C under a basic medium.

EP 4 598 315 A1

FIG. 1

FIG. 2

FIG. 3

33

Pixel Area

| PDL | 50 | PDL |
| | ETL | |
| | 30 | |
| | HTL | |

10

Substrate and Driving Circuit

Z
↑
Y ⊙→ X

FIG. 4

FIG. 5

FIG. 6

FIG. 7

## UV Norm

FIG. 8

FIG. 9

FIG. 10

**QD PL**

— ZMO

— ZMO w/Na2S 2%

FIG. 11

FIG. 12

Europäisches Patentamt

European Patent Office

Office européen des brevets

## EUROPEAN SEARCH REPORT

Application Number

EP 25 15 5215

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y<br>A | US 2023/133351 A1 (KIM KWANGHEE [KR] ET AL) 4 May 2023 (2023-05-04)<br>* abstract *<br>* figure 1 *<br>* claims 1,2, 4, 8, 14 *<br>* paragraphs [0016], [0034], [0118], [0139] *<br>* paragraphs [0130], [0195], [0205] *<br>----- | 1,3,4,<br>9-11,14<br>13,15<br>2,5-8 | INV.<br>H10K50/115<br>H10K50/16<br><br>ADD.<br>H10K102/00 |
| X<br>Y<br>A | US 2023/104394 A1 (LEE HEEJAE [KR] ET AL) 6 April 2023 (2023-04-06)<br>* abstract *<br>* figure 1 *<br>* claims 1, 4, 5, 6, 19 *<br>* paragraphs [0053], [0121], [0132], [0139] *<br>* paragraphs [0213], [0218], [0234] *<br>----- | 1,3,4,<br>9-12,14<br>13,15<br>2,5-8 | |
| T | XU J.F. ET AL: "Preparation of ZnS nanoparticles by ultrasonic radiation method",<br>APPLIED PHYSICS A,<br>vol. 66, no. 6, 1 June 1998 (1998-06-01), pages 639-641, XP093273753, Berlin/Heidelberg<br>ISSN: 0947-8396, DOI: 10.1007/s003390050725<br>* page 641 first column last paragraph, and Fig.5a *<br>----- | 9 | |
| Y<br>A | US 2023/180504 A1 (KO YUNHYUK [KR] ET AL) 8 June 2023 (2023-06-08)<br>* paragraphs [0331], [0332] *<br>----- | 13,15<br>2,5-8 | |

TECHNICAL FIELDS SEARCHED (IPC)

H10K

The present search report has been drawn up for all claims

| Place of search | Date of completion of the search | Examiner |
|---|---|---|
| Munich | 7 May 2025 | Pfattner, Raphael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 25 15 5215

This annex lists the patent family members relating to the patent documents cited in the above-mentioned European search report.
The members are as contained in the European Patent Office EDP file on
The European Patent Office is in no way liable for these particulars which are merely given for the purpose of information.

07-05-2025

| Patent document cited in search report | Publication date | Patent family member(s) | Publication date |
|---|---|---|---|
| US 2023133351 A1 | 04-05-2023 | KR 20230061287 A | 08-05-2023 |
| | | US 2023133351 A1 | 04-05-2023 |
| US 2023104394 A1 | 06-04-2023 | KR 20230047931 A | 10-04-2023 |
| | | US 2023104394 A1 | 06-04-2023 |
| US 2023180504 A1 | 08-06-2023 | CN 116234346 A | 06-06-2023 |
| | | KR 20230083387 A | 12-06-2023 |
| | | US 2023180504 A1 | 08-06-2023 |

EPO FORM P0459

For more details about this annex : see Official Journal of the European Patent Office, No. 12/82